# EUROPEAN PATENT SPECIFICATION

(11) **EP 3 163 148 B1**
(45) Date of publication and mention of the grant of the patent: **24.02.2021**
(21) Application number: 15810893.6
(22) Date of filing: 23.06.2015
(51) Int. Cl.: F16N 29/00, F16C 33/66, F16N 9/02, F16N 13/00, F16N 13/22, F16N 29/02, F16N 29/04, H01L 35/30

(54) **LUBRICATING OIL SUPPLY UNIT AND BEARING DEVICE**
SCHMIERÖLZUFÜHRUNGSEINHEIT UND LAGERVORRICHTUNG
UNITÉ D'ALIMENTATION D'HUILE DE LUBRIFICATION ET DISPOSITIF DE PALIER

(30) Priority: 27.06.2014 JP 2014132636; 16.10.2014 JP 2014211584
(43) Date of publication of application: 03.05.2017
(73) Proprietor: NTN Corporation, Osaka-shi, Osaka 550-0003 (JP)
(72) Inventor: ITO, Hiroyoshi, Kuwana-shi Mie 511-8678 (JP); TOMINAGA, Masaya, Kuwana-shi Mie 511-8678 (JP)
(74) Representative: Bockhorni & Brüntjen Partnerschaft Patentanwälte mbB
(86) International application number: PCT/JP2015/067986
(87) International publication number: WO 2015/199059

(56) References cited:
- EP-A1- 2 199 654
- DE-U1-202014 100 981
- JP-A- H06 241 234
- JP-A- H06 307 458
- JP-A- 2002 213 687
- JP-A- 2003 227 526
- JP-A- 2003 308 588
- JP-A- 2004 316 707
- JP-A- 2007 092 886
- JP-A- 2007 138 963
- JP-A- 2007 256 040
- US-A- 4 738 336
- US-A- 5 711 615

## Description

### TECHNICAL FIELD

This invention relates to a lubricating oil supply unit and a bearing apparatus and more particularly to a lubricating oil supply unit which is arranged adjacently to a bearing and supplies a lubricating oil to the inside of the bearing and a bearing apparatus.

### BACKGROUND ART

A rolling bearing apparatus incorporating an oil supply unit in the inside of a rolling bearing has conventionally been known (see Japanese Patent Laying-Open No. 2005-180629 (PTD 1) and Japanese Patent Laying-Open No. 2014-37879 (PTD 2)). In the bearing apparatus disclosed in PTD 1, a grease is sealed in the rolling bearing, a lubricating oil identical in type to a base oil of the grease is accommodated in a spacer adjacent to the rolling bearing, and the lubricating oil in the spacer is supplied as replenishment to the inside of the rolling bearing owing to a capillary phenomenon.

In the bearing apparatus disclosed in PTD 2, a lubricating oil can be supplied from a lubricating oil tank arranged in a spacer adjacent to a bearing to the bearing for a long period of time in a stable manner by intermittently operating a pump.

### CITATION LIST

### PATENT DOCUMENT

PTD 1: Japanese Patent Laying-Open No. 2005-180629
PTD 2: Japanese Patent Laying-Open No. 2014-37879

### SUMMARY OF INVENTION

### TECHNICAL PROBLEM

In the apparatus disclosed in PTD 1 described above, the grease is sealed in advance in the bearing for lubrication, however, the base oil of the grease simultaneously accommodated in the spacer is also constantly supplied to the inside of the bearing. Therefore, supply of the lubricating oil tends to be excessive and consumption of the base oil (the lubricating oil) in the spacer is also fast. Therefore, it is difficult to supply the lubricating oil to the bearing for a long period of time in a stable manner.

In the apparatus disclosed in PTD 2, the lubricating oil can presumably be supplied for a longer period of time than in the apparatus disclosed in PTD 1, however, a state of supply of the lubricating oil cannot be checked from the outside of the bearing apparatus. Therefore, even when supply of the lubricating oil may fail due to such a factor as failure in operation of a pump or the like, it is difficult to know occurrence of such a failure in supply of the lubricating oil until an abnormal condition in operations of the bearing occurs. Therefore, it is difficult to detect the abnormal condition of the bearing apparatus in an early stage and to take measures such as maintenance in order to operate the bearing apparatus for a long period of time in a stable manner.

This invention was made to solve the problems as above, and an object of this invention is to provide a lubricating oil supply unit and a bearing apparatus which can be operated for a long period of time in a stable manner.

### SOLUTION TO PROBLEM

A lubricating oil supply unit according to the present invention is defined in claim 1 and includes a holding portion which holds a lubricating oil supplied to the inside of a bearing, a supply portion which supplies the lubricating oil from the holding portion to the inside of the bearing, and a control unit for controlling operations of the supply portion. The control unit can obtain data on a condition of supply of the lubricating oil and output the data to the outside of the control unit.

A bearing apparatus according to the the present invention is defined in claim 20 and includes the lubricating oil supply unit and a bearing connected to the lubricating oil supply unit.

### ADVANTAGEOUS EFFECTS OF INVENTION

According to the above, a lubricating oil supply unit and a bearing apparatus which can be operated for a long period of time in a stable manner can be obtained.

### BRIEF DESCRIPTION OF DRAWINGS

Fig. 1 is a schematic cross-sectional view showing one example of a mechanical apparatus according to the present first embodiment.
Fig. 2 is a schematic cross-sectional view of the mechanical apparatus shown in Fig. 1.
Fig. 3 is a schematic plan view of a monitoring unit attached to the mechanical apparatus shown in Fig. 1.
Fig. 4 is a block diagram for illustrating a construction of the mechanical apparatus shown in Fig. 1.
Fig. 5 is a block diagram for illustrating a configuration of a control circuit and the monitoring unit in the lubricating oil supply unit of the mechanical apparatus shown in Fig. 1.
Fig. 6 is a schematic diagram showing the entire bearing apparatus.
Fig. 7 is a schematic cross-sectional view along the line segment VII-VII in Fig. 6.
Fig. 8 is a schematic cross-sectional view along the line segment VIII-VIII in Fig. 6.
Fig. 9 is a schematic cross-sectional view along the line segment IX-IX in Fig. 6.
Fig. 10 is an enlarged schematic diagram of a region X in Fig. 6.
Fig. 11 is a graph showing a first example of relation between a power storage voltage of a power storage portion included in a power supply portion of the lubricating oil supply unit and time.
Fig. 12 is a graph showing a second example of relation between a power storage voltage of the power storage portion included in the power supply portion of the lubricating oil supply unit and time.
Fig. 13 is a graph showing a third example of relation between a power storage voltage of the power storage portion included in the power supply portion of the lubricating oil supply unit and time.
Fig. 14 is a graph showing a fourth example of relation between a power storage voltage of the power storage portion included in the power supply portion of the lubricating oil supply unit and time.
Fig. 15 is a graph showing a fifth example of relation between a power storage voltage of the power storage portion included in the power supply portion of the lubricating oil supply unit and time.
Fig. 16 is a graph showing a sixth example of relation between a power storage voltage of the power storage portion included in the power supply portion of the lubricating oil supply unit and time.
Fig. 17 is a schematic plan view showing a modification of the monitoring unit attached to the mechanical apparatus shown in Fig. 1.
Fig. 18 is a block diagram for illustrating a first modification of the configuration of the control circuit and the monitoring unit in the lubricating oil supply unit of the mechanical apparatus shown in Fig. 1.
Fig. 19 is a block diagram for illustrating a second modification of the configuration of the control circuit and the monitoring unit in the lubricating oil supply unit of the mechanical apparatus shown in Fig. 1.
Fig. 20 is a schematic cross-sectional view showing one example of the mechanical apparatus according to the present second embodiment.
Fig. 21 is a schematic cross-sectional view of the mechanical apparatus shown in Fig. 20.
Fig. 22 is a block diagram for illustrating a construction of the mechanical apparatus shown in Fig. 20.
Fig. 23 is a block diagram for illustrating a configuration of the control circuit and the monitoring unit in the lubricating oil supply unit of the mechanical apparatus shown in Fig. 20.
Fig. 24 is a schematic plan view showing a modification of the monitoring unit attached to the mechanical apparatus shown in Fig. 20.
Fig. 25 is a flowchart showing a modification of operations of a reception portion in the lubricating oil supply unit of the mechanical apparatus shown in Fig. 20.
Fig. 26 is a block diagram for illustrating a modification of a configuration of the control circuit and the monitoring unit in the lubricating oil supply unit of the mechanical apparatus shown in Fig. 20.

### DESCRIPTION OF EMBODIMENTS

An embodiment of the present invention will be described hereinafter with reference to the drawings. The same or corresponding elements in the drawings below have the same reference characters allotted and description thereof will not be repeated.

### (First Embodiment)

### <Construction of Mechanical Apparatus>

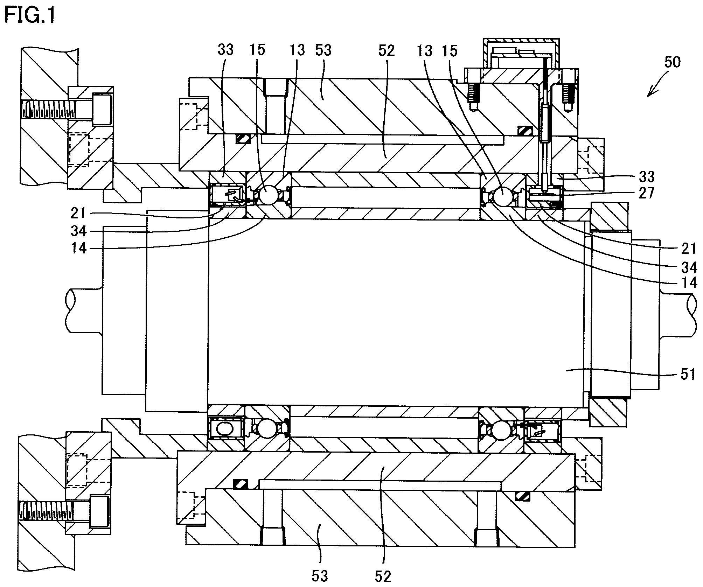

A construction of a machine tool spindle representing one example of a mechanical apparatus to which a bearing apparatus according to the present first embodiment is applied will be described with reference to Figs. 1 to 5.

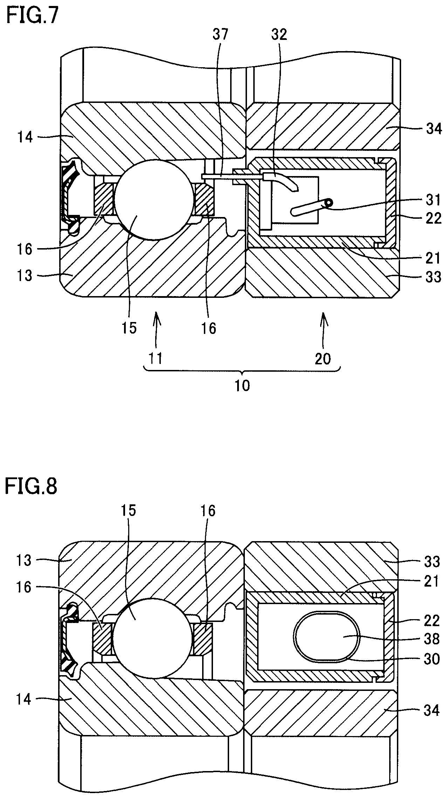

As shown in Figs. 1 to 5, a machine tool spindle 50 according to the present first embodiment mainly includes a rotation shaft 51, a spindle housing 52 arranged to surround rotation shaft 51, an outer circumferential housing 53 arranged around an outer circumference of spindle housing 52, and a bearing apparatus which rotatably holds rotation shaft 51 with respect to spindle housing 52. Two bearing apparatuses are arranged around the outer circumference of rotation shaft 51. An inner ring 14 and an inner ring spacer 34 of a bearing in the bearing apparatus are fitted and fixed to a side surface of rotation shaft 51. An outer ring 13 and an outer ring spacer 33 of the bearing are fitted and fixed to an inner circumferential surface of spindle housing 52. The bearing including inner ring 14, outer ring 13, and a rolling element 15 which is a ball arranged between inner ring 14 and outer ring 13 is an angular ball bearing. A lubricating oil supply unit 20 (see Fig. 7) is arranged between inner ring spacer 34 and outer ring spacer 33 which are arranged adjacently to the bearing. Between two bearings (a side opposite to a side where the lubricating oil supply unit is arranged), another spacer is fitted and fixed to rotation shaft 51 and spindle housing 52 and abuts on inner ring 14 and outer ring 13.

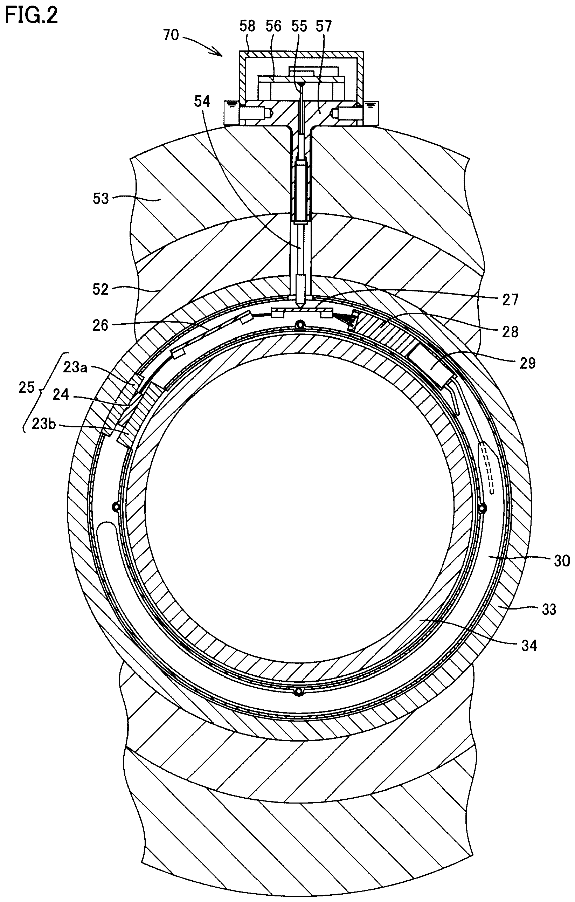

As shown in Fig. 2, lubricating oil supply unit 20 mainly includes a power generation portion 25 arranged along a circumferential direction in an annular housing, a power supply circuit 26 including a power storage portion, a control circuit 27, a drive circuit 28, a pump 29, and a lubricating oil tank 30 holding a lubricating oil 38 (see Fig. 8). A detailed construction of the bearing apparatus including lubricating oil supply unit 20 will be described later.

In a region of the lubricating oil supply unit opposed to control circuit 27, a through hole which passes through a housing main body 21 (see Fig. 7), outer ring spacer 33, spindle housing 52, and outer circumferential housing 53 is provided. At an end portion on an outer circumferential side of the through hole, a planar portion is provided on a surface of outer circumferential housing 53 and a base 57 is arranged on the planar portion. An output substrate 56 is arranged on base 57. Output substrate 56 and control circuit 27 of lubricating oil supply unit 20 are electrically connected to each other through a contact probe 54. Contact probe 54 is arranged in the inside of the through hole. Contact probe 54 has one end in contact with an electrode pad (not shown) of control circuit 27 and has the other end connected to output substrate 56 through a conductive line 55. Contact probe 54 may be connected and fixed to a side of output substrate 56.

A cover member 58 is fixed to base 57 so as to cover output substrate 56 arranged on base 57. A battery 60 representing a power supply for driving a circuit on output substrate 56 and a storage portion 59 are arranged on output substrate 56. For example, a coin battery or a button battery can be employed as battery 60. Though a lithium battery is desirably employed as battery 60, a nickel metal hydride rechargeable battery may be employed. A holder for fixing such battery 60 is arranged on a surface of output substrate 56. For example, a holding portion (a slot) for connecting and fixing a card-type external storage medium and an external storage medium removably fixed to the holding portion can be employed as storage portion 59. Any conventionally well-known storage medium such as a memory card can be made use of as an external storage medium.

In cover member 58, a U-shaped elongated hole portion (a hole in which a fixing bolt representing a member for connection to base 57 is arranged) is provided such that the cover member can be removed from base 57 simply by loosening a fixing bolt. Battery 60 or an external storage medium can be replaced with cover member 58 being removed from base 57.

Output substrate 56 hermetically sealed by base 57 and cover member 58 implements a main portion of a voltage monitoring unit. Any waterproof structure can be added to base 57 and cover member 58 in order to prevent entry of a coolant used during working with the use of a working machine spindle. For example, a gasket, an O-ring, caulking, or a resin mold can be employed for a waterproof structure.

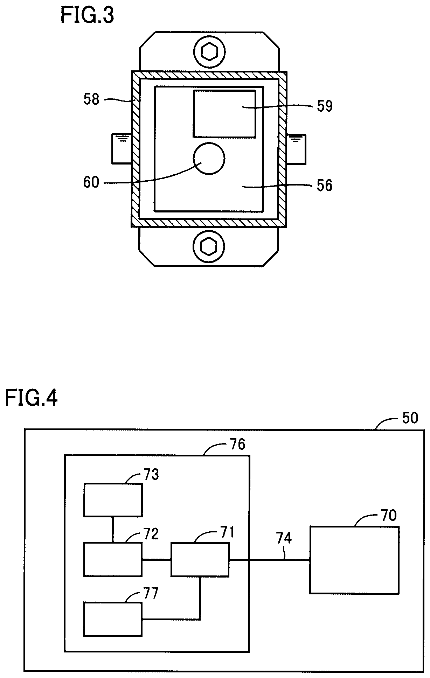

A construction of the lubricating oil supply unit which is provided in machine tool spindle 50 described above and includes a voltage monitoring unit will be described mainly with reference to Fig. 4.

Machine tool spindle 50 described above includes a lubricating oil supply unit including a unit main body portion 76 connected to a bearing 11 (see Fig. 7) including inner ring 14, outer ring 13, and rolling element 15 and including a control unit 71 having control circuit 27 (see Fig. 2) and an external output portion 70 representing a voltage monitoring unit connected to control unit 71 through a connection line 74 (contact probe 54). Unit main body portion 76 includes control unit 71 including control circuit 27, a power supply portion 77 including power generation portion 25 (see Fig. 2) and power supply circuit 26 (see Fig. 2), a lubricating oil supply portion 72 including power supply circuit 26, drive circuit 28, and pump 29, and a lubricating oil holding portion 73 (lubricating oil tank 30). Control unit 71 is connected to power supply portion 77 and lubricating oil supply portion 72, controls a state of supply of a lubricating oil in lubricating oil supply portion 72, and obtains data on a state of supply of the lubricating oil. The data includes data on timing of supply of the lubricating oil, an interval of supply of the lubricating oil, and a voltage (a power storage voltage) in the power supply circuit (specifically, the power storage portion) at the time of operation of pump 29, as will be described later.

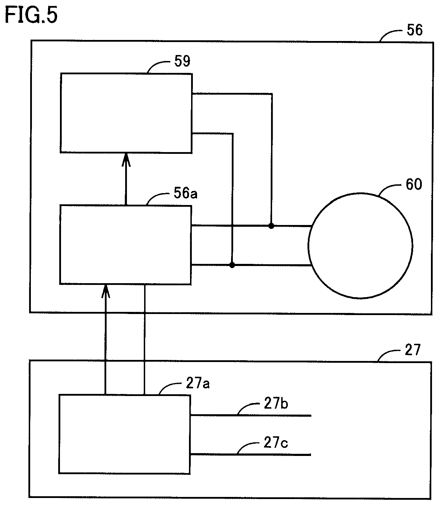

Any construction can be adopted for a construction for a portion of connection between control circuit 27 of control unit 71 and output substrate 56 of external output portion 70. For example, as shown in Fig. 5, a processor 27a (a microcomputer) provided in control circuit 27 and a processor 56a of output substrate 56 may be connected to each other through connection line 74. Processor 27a of control circuit 27 is connected to a power supply or a ground portion through lines 27b and 27c. On output substrate 56, processor 56a is connected to battery 60 and storage portion 59. A signal representing data such as a voltage (a signal transmitted from control circuit 27) can be transmitted from processor 56a to storage portion 59.

According to the construction as above, data on a condition of supply of a lubricating oil transmitted from control circuit 27 is stored in storage portion 59 on output substrate 56. Any timing can be adopted as timing of transmission of the data from control circuit 27 to output substrate 56. For example, the data may be transferred from control circuit 27 to output substrate 56 at the time point at which the storage portion of control circuit 27 (a storage element included in processor 27a or a storage element provided in control circuit 27 independently of processor 27a) is filled with the data. When the data includes data on change over time in power storage voltage of power supply portion 77, the data can be saved in an external storage medium through storage portion 59 on output substrate 56 and taken into an external computer by using the external storage medium. By doing so, a condition of the lubricating oil supply unit (a state of power generation or a state of operations of pump 29) can be checked on the external computer.

### <Construction of Bearing Apparatus>

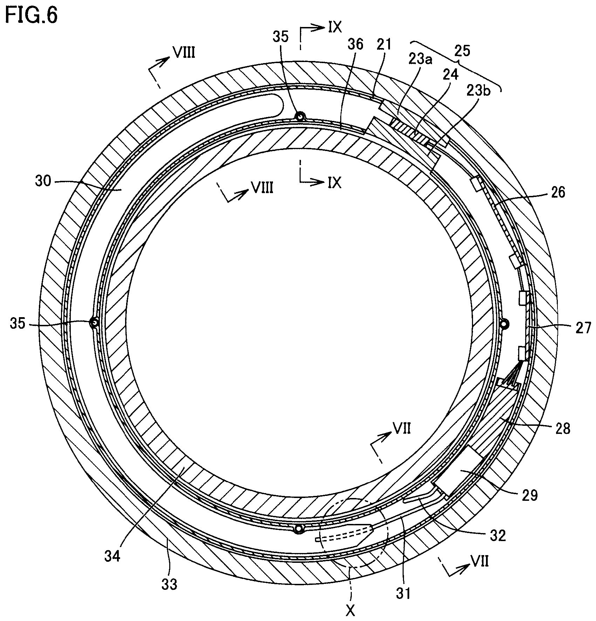

A bearing apparatus included in the mechanical apparatus shown in Fig. 1 will be described with reference to Figs. 6 to 10. A bearing apparatus 10 according to the present embodiment is a rolling bearing apparatus, and includes bearing 11 (see Fig. 7) representing a rolling bearing and lubricating oil supply unit 20 (see Fig. 7). Lubricating oil supply unit 20 is incorporated between outer ring spacer 33 and inner ring spacer 34 which abut on one end portion in an axial direction of bearing 11. Bearing apparatus 10 including bearing 11 and lubricating oil supply unit 20 is used as being incorporated, for example, between the rotation shaft and the housing of the mechanical apparatus. When bearing apparatus 10 is incorporated in the mechanical apparatus, for example, another spacer abuts also on another end portion of bearing 11 so that bearing 11 can be positioned in the axial direction by outer ring spacer 33 and inner ring spacer 34 and another spacer.

Bearing 11 mainly includes inner ring 14 which is a rolling bearing ring, for example, on a rotation side, outer ring 13, for example, on a fixed side, a plurality of rolling elements 15 interposed between inner ring 14 and outer ring 13, a retainer 16 retaining the plurality of rolling elements 15 at a constant interval, and a sealing member arranged on the outer circumferential side of retainer 16. For example, an angular ball bearing, a deep-groove ball bearing, or a cylindrical roller bearing can be employed as bearing 11. A desired grease is sealed in advance in bearing 11. The sealing member is arranged at an end portion opposite to a side where outer ring spacer 33 is arranged.

A spacer is constituted of inner ring spacer 34 and outer ring spacer 33, and inner ring spacer 34 abuts on one end surface of inner ring 14. Outer ring spacer 33 abuts on one end surface of outer ring 13.

As shown in Figs. 6 to 9, lubricating oil supply unit 20 mainly includes in the circumferential direction, power generation portion 25, power supply circuit 26 including a charging portion, control circuit 27, drive circuit 28, pump 29, and lubricating oil tank 30 which are arranged in an annular housing. Lubricating oil tank 30 stores a lubricating oil identical in type to the base oil of the grease sealed in bearing 11. Power generation portion 25, power supply circuit 26, control circuit 27, drive circuit 28, pump 29, and lubricating oil tank 30 are arranged as being aligned in the circumferential direction in housing main body 21. Power generation portion 25 is connected to power supply circuit 26. Power supply circuit 26 is connected to control circuit 27. Control circuit 27 is connected to drive circuit 28. Drive circuit 28 is a circuit for operating pump 29 such as a micropump. A sucking tube 31 connected to a bag body of lubricating oil tank 30 and a discharge tube 32 for supplying the lubricating oil from pump 29 to the inside of bearing 11 are connected to pump 29 connected to drive circuit 28. A nozzle 37 is connected to a tip end portion of discharge tube 32 (an end portion opposite to a root portion connected to pump 29) as shown in Fig. 7. The tip end portion of nozzle 37 extends to the inside of bearing 11 (a position adjacent to rolling element 15, for example, a position between the rolling bearing ring on the fixed side and the rolling bearing ring on the rotation side of bearing 11). A dimension of an inner diameter of a nozzle hole of nozzle 37 is set as appropriate depending on relation between surface tension resulting from a viscosity of the base oil and an amount of discharge.

As will be described later, control circuit 27 can obtain data on a condition of supply of the lubricating oil in lubricating oil supply unit 20 and output the data to the outside of control circuit 27 (for example, to output substrate 56 (see Fig. 2) as a reception portion).

As shown in Fig. 6, an element generating electric power based on the Seebeck effect is employed as power generation portion 25 of lubricating oil supply unit 20. Specifically, power generation portion 25 includes a heat conductor 23a connected to outer ring spacer 33, a heat conductor 23b arranged in inner ring spacer 34, and a thermoelectric element 24 (an element making use of the Seebeck effect of a Peltier element) arranged to connect heat conductor 23a and heat conductor 23b to each other and fixed as being in intimate contact with heat conductors 23a and 23b.

When a rolling bearing apparatus is employed as bearing apparatus 10 as shown in Fig. 6, a temperature of inner ring 14 and outer ring 13 increases due to heat resulting from friction with rolling element 15 (see Fig. 7). Since outer ring 13 is normally incorporated in a housing of equipment, heat is radiated therefrom by heat conduction. Therefore, a temperature is different between inner ring 14 and outer ring 13 (inner ring 14 is higher in temperature than outer ring 13). That temperature conducts to each of heat conductors 23a and 23b. Heat conductors 23a and 23b are arranged to pass through an inner circumferential surface and an outer circumferential surface of housing main body 21. Therefore, a temperature is different between opposing end surfaces of thermoelectric element 24 arranged between heat conductor 23a (a heat sink) connected to outer ring 13 with outer ring spacer 33 being interposed and heat conductor 23b located on a side of inner ring spacer 34 (a side of inner ring 14). Therefore, thermoelectric element 24 can generate electric power owing to the Seebeck effect. Since it is not necessary to externally supply electric power to the lubricating oil supply unit by employing such power generation portion 25, it is not necessary to attach an electric wire for externally supplying electric power to machine tool spindle 50. Therefore, it is more effective to employ lubricating oil supply unit 20 with means for checking supply of the lubricating oil to bearing 11 as described above.

An adhesive of which thermal conductivity is taken into account is preferably used for a surface of heat conductor 23a which passes through the outer circumferential surface of housing main body 21, the surface being in contact with the inner circumferential surface of outer ring spacer 33. The outer circumferential surface of heat conductor 23a on the side of outer ring 13 is preferably identical in radius of curvature to the inner circumferential surface of outer ring spacer 33. Then, the inner circumferential surface of outer ring spacer 33 and the outer circumferential surface of heat conductor 23a can be in intimate contact with each other, and hence heat can efficiently conduct between heat conductor 23a, and outer ring spacer 33 and outer ring 13. The inner circumferential surface (a surface opposed to inner ring spacer 34) of heat conductor 23b on the side of the inner ring is not in contact with inner ring spacer 34. If possible, heat conductor 23a on the side of the outer ring and heat conductor 23b on the side of the inner ring are desirably equal to each other in volume. A surface area of heat conductor 23b on the side of the inner ring is desirably larger.

For enhancing thermal conductivity and adhesiveness, a thermal grease is preferably applied between the inner circumferential surface of outer ring spacer 33 and heat conductor 23a, between heat conductor 23a and thermoelectric element 24, and between thermoelectric element 24 and heat conductor 23b on the side of the inner ring. Generally, the thermal grease is mainly composed of silicone. A metal high in thermal conductivity is preferably employed for a material for heat conductors 23a and 23b. For example, silver (Ag), copper (Cu), or gold (Au) can be employed, and copper is preferably employed from a point of view of cost. A copper alloy mainly composed of copper may be employed for a material for heat conductors 23a and 23b, and a sintered alloy mainly composed of copper may be employed. A heat conductor connected to thermoelectric element 24 is arranged only on a high-temperature side, and thermoelectric element 24 is fixed as being in intimate contact with a spacer (outer ring spacer 33) on a low-temperature side.

Charges generated by power generation portion 25 are stored in power supply circuit 26. Specifically, the charges are stored in a power storage portion such as a storage battery or a capacitor included in power supply circuit 26 (also called a power storage circuit). An electric double layer capacitor is preferably employed as the capacitor.

Control circuit 27 is a control unit for controlling operations of pump 29 through drive circuit 28, and includes a program storage portion holding a control program and a processor (a microcomputer) connected to the program storage portion and executing the control program. Control circuit 27 can set in advance timing to start supply of the lubricating oil to bearing 11, timing of supply (an interval), a time period for driving pump 29 for supplying the lubricating oil, and an amount of supply of the lubricating oil. A lubrication lifetime of the bearing apparatus can be extended by thus properly keeping a state of supply of the lubricating oil.

Drive circuit 28 as a drive portion may include, for example, any sensor (a bearing temperature sensor, a bearing rotation sensor, a lubricating oil remaining amount sensor, or a lubricating oil temperature sensor). A signal from such a sensor may be input to a processor (a microcomputer) of drive circuit 28 so that pump 29 is automatically controlled in accordance with a temperature of bearing 11 and a condition of rotation thereof so as to adjust an amount of supply of the lubricating oil.

Pump 29 is controlled by control circuit 27 through drive circuit 28. Pump 29 sucks the lubricating oil in lubricating oil tank 30 through sucking tube 31 and supplies the sucked lubricating oil to the inside of bearing 11 through discharge tube 32 and nozzle 37.

As shown in Fig. 7, the annular housing of lubricating oil supply unit 20 is constituted of housing main body 21 having such a cross-section in a bracket shape that a surface opposite to bearing 11 is open and a lid 22 which closes an opening in housing main body 21 and is attachable to and removable from housing main body 21. Housing main body 21 and lid 22 may be formed of any material, and may be formed, for example, of a resin material and more preferably of a thermoplastic resin. For example, polyphenylene sulfide (PPS) can be employed as a material forming the housing. Housing main body 21 and lid 22 may be formed of a material of the same type or from different materials.

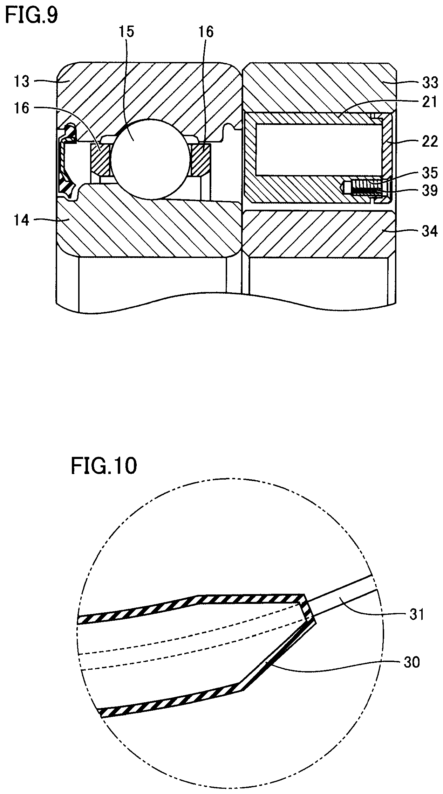

Lid 22 of the housing may be fixed to housing main body 21 with a screw 39 (see Fig. 9). By fixing lid 22 to housing main body 21, the inside of the housing surrounded by housing main body 21 and lid 22 can hermetically be sealed. Lid 22 can be removed by removing screw 39 from a tap hole 35 in which screw 39 is fixed. By doing so, lubricating oil tank 30 accommodated in housing main body 21 can be replenished with the lubricating oil without removing entire lubricating oil supply unit 20 from bearing apparatus 10.

The outer circumferential surface of housing main body 21 may be fixed to the inner circumferential surface of outer ring spacer 33. The outer circumferential surface of housing main body 21 and outer ring spacer 33 may be bonded and fixed to each other, for example, with an adhesive. For example, an epoxy resin may be used as an adhesive for bonding and fixing housing main body 21. Housing main body 21 (that is, lubricating oil supply unit 20) may be fixed to a stationary ring of bearing 11. A gap 36 may be provided between housing main body 21 and inner ring spacer 34.

Lubricating oil tank 30 accommodated in housing main body 21 may be formed from a bag body made of a flexible resin. Lubricating oil tank 30 may be arranged in a shape of an arc along annular housing main body 21.

The bag body made of a resin which forms lubricating oil tank 30 may be formed, for example, by layering resin sheets and thermally welding outer peripheral portions as shown in Fig. 10 as being enlarged. For example, the outer peripheral portions of lubricating oil tank 30 shown in Fig. 10 may be a thermally welded portion.

Sucking tube 31 connected to pump 29 is provided in the bag body of lubricating oil tank 30. In forming the bag body of lubricating oil tank 30 by thermal welding, sucking tube 31 is thermally welded as being sandwiched between the resin sheets layered for forming the bag body. Sucking tube 31 can thus be integrated with the bag body.

Any other construction can be adopted for the construction of the bag body forming lubricating oil tank 30. For example, the bag body may be formed by blow molding. In this case, sucking tube 31 may be blow molded integrally with the bag body. As the bag body of lubricating oil tank 30 is blow molded as above, the bag body is in an inflated shape (a shape like a sack), and hence a portion like a sack is desirably formed to be flat after molding of the bag body. By forming the portion like a sack to be flat, the lubricating oil can fully be discharged from lubricating oil tank 30 even when an amount of the lubricating oil becomes small. The lubricating oil in lubricating oil tank 30 can be used up.

Any material can be employed as a material for the bag body forming lubricating oil tank 30, and for example, a resin material is preferably employed. For example, nylon, polyethylene, polyester, or polypropylene can be employed as a material for lubricating oil tank 30, and a material is not particularly limited so long as a material has resistance to a lubricating oil accommodated in the bag body.

Sucking tube 31 provided in the bag body of lubricating oil tank 30 may removably be connected to pump 29. With sucking tube 31 being removable from pump 29, when the lubricating oil no longer remains in lubricating oil tank 30, sucking tube 31 can be detached from pump 29 and the bag body can be replenished with the lubricating oil through sucking tube 31.

With the bag body of lubricating oil tank 30 being removable from pump 29, a spare bag body filled with the lubricating oil can be prepared so that the bag body can be replaced therewith. For example, when no lubricating oil is left in lubricating oil tank 30 which is being used, replenishment with the lubricating oil in lubricating oil supply unit 20 can be finished in a short period of time by removing the used bag body of lubricating oil tank 30 and replacing the bag body with a spare bag body (a bag body filled with the lubricating oil).

The spare bag body described above can be filled with the lubricating oil under management by a manufacturer of the lubricating oil. By doing so, a probability of occurrence of a problem at the time of filling such as entry of a foreign matter into the bag body can be lowered. While the spare bag body is stored, a lid is preferably attached to sucking tube 31 of the spare bag body. By doing so, introduction of a foreign matter into the stored bag body can be prevented.

The bearing apparatus above is of an inner ring rotation type. Though rotation around the horizontal axis is assumed, rotation around the vertical axis is also applicable.

### <Operations of Mechanical Apparatus>

In machine tool spindle 50 representing one example of the mechanical apparatus shown in Fig. 1, rotation shaft 51 is connected to a prescribed drive shaft so that rotation with respect to spindle housing 52 can be made. In the bearing apparatus supporting rotation shaft 51, the lubricating oil is regularly supplied to bearing 11 (see Fig. 7) by the lubricating oil supply unit so as to enhance reliability and durability of machine tool spindle 50.

### <Operations of Bearing Apparatus>

In the bearing apparatus including bearing 11 and lubricating oil supply unit 20 (see Fig. 7), the lubricating oil can be supplied from lubricating oil tank 30 to bearing 11 under control of operations of pump 29 by control circuit 27.

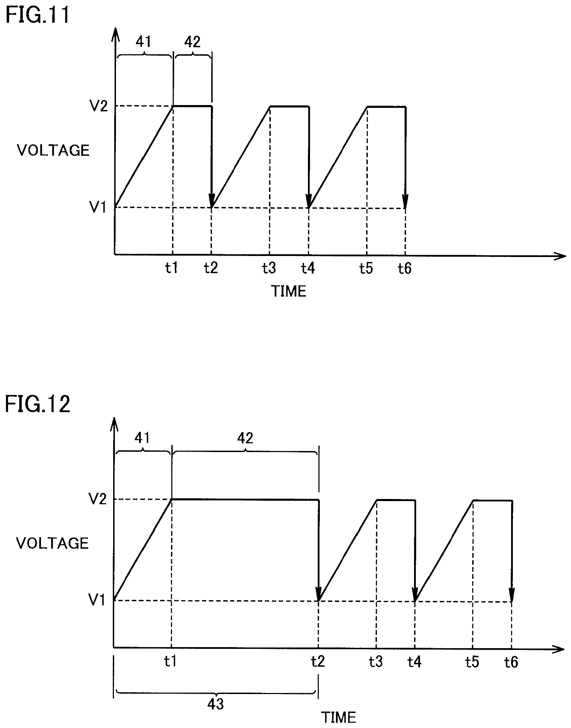

Pump 29 can be driven at the time point when a voltage of a power storage portion (for example, a capacitor) in power supply circuit 26 reaches a certain voltage as electric power generated by power generation portion 25 is stored in the power storage portion. In order to extend the lubrication lifetime of bearing 11 in which a grease is sealed and to extend a time period until maintenance, an interval as below is desirable. Specific description will be given below with reference to Figs. 11 to 16. In Figs. 11 to 16, the ordinate represents a voltage of the power storage portion and the abscissa represents time. Figs. 11 to 16 show change over time in voltage of the power storage portion (a condition of charging and discharging).

For example, referring to Fig. 11, when lapse of a charging time period 41 until a voltage of the power storage portion reaches a voltage (a voltage V2 in Fig. 11) necessary for driving pump 29 (or a fully charged state is achieved) is earlier than timing of supply of the required lubricating oil, pump 29 is driven with electric power stored in the power storage portion at a time point t2 with a prescribed period of time for power storage (a delay time period 42) being added also after a time point t1 at which the voltage of the power storage portion reaches voltage V2 (the power storage portion is fully charged) (that is, a delay time period from time point t1 to time point t2 being added). Thus, an interval of supply of the lubricating oil can be managed to be longer than a time period for a voltage of the power storage portion to reach a prescribed voltage (for example, a fully charged state).

As shown in Fig. 11, after a voltage of the power storage portion lowers to voltage V1 by driving pump 29 once, a charging operation is performed again. Consequently, a voltage of the power storage portion attains to a prescribed voltage (a time point t3). Thereafter, after the delay time period described above elapses (a time point t4), pump 29 is driven again. Such a cycle can be continued also thereafter (for example, from time point t4 until a time point t6).

As shown in Fig. 12, delay time period 42 (a time period from time point t1 to time point t2) can be set to be longer in consideration of a lifetime of the grease originally sealed in bearing 11. For example, when a bearing of a grease sealed type is employed as bearing 11, sufficient lubrication can be ensured by the grease sealed in bearing 11 at an initial stage of operation. Therefore, as shown in Fig. 12, first supply of the lubricating oil may be started after lapse of a lubrication lifetime (for example, twenty thousand hours) achieved by the grease sealed in bearing 11. Any timing such as a time point at which a charging voltage of the power storage portion reaches a certain value or a time point at which an output voltage from thermoelectric element 24 reaches a certain value may be adopted as a time point of start of operation of bearing 11.

In this case, delay time period 42 can be set, for example, such that a time period from start of operation until time point t2 is comparable to a lubrication lifetime 43 of the grease. In determining time point t2, time since the time point of start of operation may be counted with a timer function of control circuit 27 and the time point of lapse of lubrication lifetime 43 may be set as time point t2. A delay time period in a second cycle or later (a time period between time point t3 and time point t4 or a time period between time point t5 and time point t6) can be set to be shorter than first delay time period 42 also in consideration of a condition of use of the bearing apparatus, because the base oil of the grease in bearing 11 may have considerably decreased. By thus delaying first supply of the lubricating oil, a lifetime of bearing 11 can be longer and a time period until maintenance can be longer.

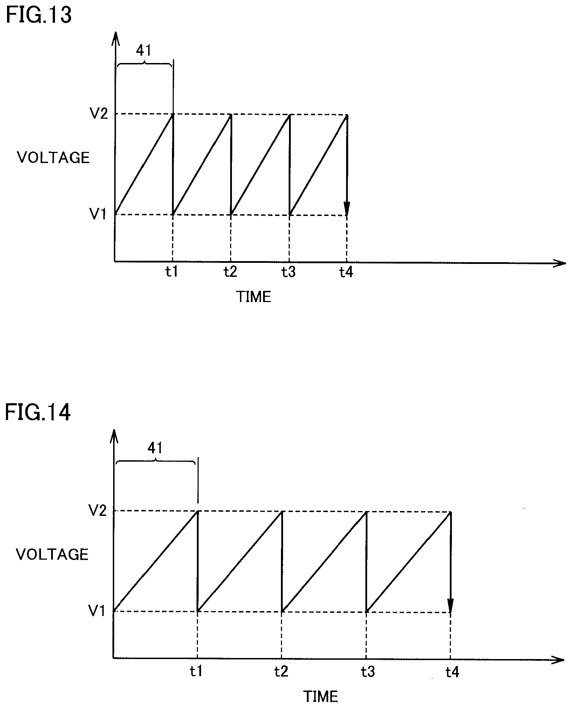

As shown in Fig. 13, an interval of discharge of the lubricating oil (an operation interval of pump 29) may be controlled in accordance with a time period until the power storage portion is fully charged. For example, charging and discharging of the power storage portion may be repeated and pump 29 may be driven every prescribed number of cycles of charging and discharging. Specifically, at time point t1, time point t2, and time points t3 and t4 in Fig. 13, only discharging from the power storage portion to a resistor is carried out and pump 29 is not driven. At time point t4 at which the power storage portion is fully charged (a voltage of the power storage portion attains to voltage V2) in the fourth charging and discharging cycle, pump 29 is driven. By thus driving pump 29 every prescribed number of charging and discharging cycles, an interval for supply of the lubricating oil can be managed to be longer.

Power generation portion 25 of lubricating oil supply unit 20 generates electric power by making use of a temperature difference between inner ring 14 and outer ring 13 of bearing 11. Therefore, in such an operation condition that a temperature of inner ring 14 of bearing 11 is relatively high, a temperature difference between inner ring 14 and outer ring 13 is large and consequently an amount of electric power generation per unit time by power generation portion 25 increases. Therefore, a time period for charging the power storage portion in power supply circuit 26 is shorter. In contrast, when a difference in temperature between inner ring 14 and outer ring 13 of bearing 11 is not so great, an amount of electric power generation per unit time by power generation portion 25 is small. Therefore, a time period for charging the power storage portion in power supply circuit 26 is longer.

When Fig. 13 described above is assumed to correspond to an example in which a temperature difference between inner ring 14 and outer ring 13 is great, Fig. 14 shows an example in which a temperature difference between inner ring 14 and outer ring 13 of bearing 11 is relatively smaller than in the example shown in Fig. 13 and consequently a charging time period is longer. It can be seen based on comparison between Figs. 13 and 14 that charging time period 41 (for example, a time period from start of charging until time point t1) is longer in the graph shown in Fig. 14. When the charging and discharging cycle is used for determination of an interval of drive of pump 29 as shown in Fig. 13, an interval of supply of the lubricating oil varies depending on a temperature difference between inner ring 14 and outer ring 13 of bearing 11.

In general, when a condition for lubrication in bearing 11 is satisfactory, temperature increase in the inside of bearing 11 is relatively small and a long interval of supply of the lubricating oil does not give rise to a problem. When a condition for lubrication in the inside of bearing 11 is not much satisfactory, temperature increase in the inside of bearing 11 is relatively great and an interval of supply of the lubricating oil is desirably shorter.

Therefore, when electric power generation based on a temperature difference between inner ring 14 and outer ring 13 of bearing 11 is made use of, an interval of supply of the lubricating oil is automatically varied depending on a load in bearing 11 so that a condition for lubrication in the inside of bearing 11 can always be kept satisfactory. Under the control shown in Figs. 13 and 14, charging and discharging are repeated until pump 29 is driven. Therefore, an interval of drive of pump 29 may be managed based on the number of times of charging and discharging.

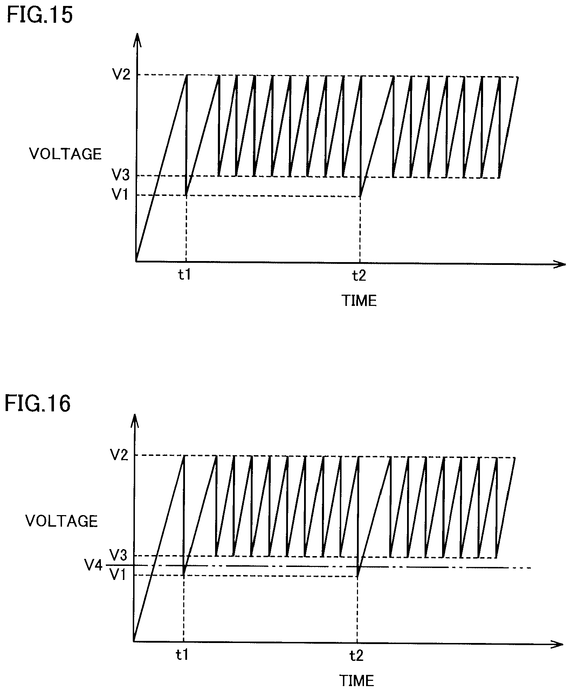

For example, as shown in Fig. 15, an interval of drive of pump 29 may be managed so as to repeat such a cycle that pump 29 is once driven (time point t1), thereafter charging and discharging are repeated eight times, and pump 29 is driven when full charge is achieved for the ninth time (time point t2 when voltage V2 is reached). Change over time in voltage as shown in Fig. 15 may be stored in control circuit 27 and thereafter output to output substrate 56.

When a time period until full charge is short in charging of the power storage portion, it is estimated that a temperature difference between outer ring 13 and inner ring 14 in bearing 11 is great (a temperature of the inner ring is high). In contrast, when a time period until full charge is long, it is estimated that a temperature of the inner ring is relatively lower than in the above-described example. Therefore, it may be determined that a state of lubrication in the inside of bearing 11 generally does not tend to be so good when a charging time period is relatively short, and a state of lubrication in the inside of bearing 11 is generally good when a charging time period is long. By thus counting time until full charge, change in state of lubrication in the inside of bearing 11 can indirectly be estimated without separately providing such a device as a temperature sensor in bearing 11. For such estimation, relation between a time period until full charge and a state of lubrication in the inside of bearing 11 may be found, for example, through running tests. In this case, relation between a time period and a state of lubrication in the inside of bearing 11 changes depending on a rotation speed of bearing 11, magnitude of load, and an amount of pre-load. In the case of machine tool spindle 50, the outer circumferential side of spindle housing 52 is always cooled by cooling water or cooling oil.

Based on comparison between an example in which pump 29 is driven and an example in which the power storage portion discharges simply by using a resistor, lowering in voltage in the power storage portion may be greater when pump 29 is driven. For example, as shown in Fig. 16, an example in which a voltage of the power storage portion lowers to voltage V1 when pump 29 is driven at time point t1 or time point t2, whereas a voltage of the power storage portion lowers to a voltage V3 when the power storage portion discharges simply by using a resistor is considered. Here, voltage V1 is lower than voltage V3. In this case, with a voltage V4 between voltage V1 and voltage V3 being set as a threshold value, when a voltage of the power storage portion lowers to a voltage equal to or lower than the threshold value, the timing of lowering of the voltage (for example, time point t1 or time point t2) and a voltage value (voltage V1) may be stored in control circuit 27. Information on specific time and date may be used as information on timing.

As set forth above, data on timing of drive of pump 29 or change over time in voltage of the power storage portion is stored in control circuit 27 and further output from control circuit 27 to output substrate 56 (external output portion 70), so that a condition of operations of the lubricating oil supply unit (and a condition of bearing 11) can readily be checked.

### <Modification of Construction of Mechanical Apparatus>

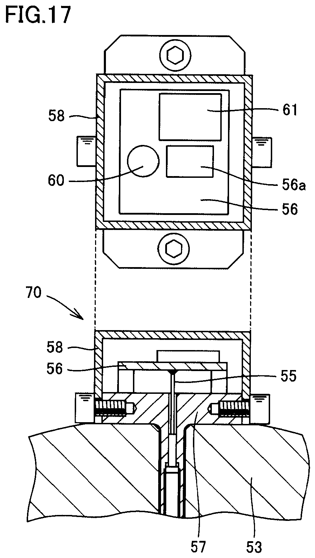

A modification of the mechanical apparatus according to the present embodiment will be described with reference to Figs. 17 to 19.

Referring to Fig. 17, a first modification of machine tool spindle 50 representing one example of the mechanical apparatus is basically identical in construction to machine tool spindle 50 shown in Fig. 1, however, a display 61 is provided on output substrate 56. Any display such as a liquid crystal display can be employed as display 61. A window portion provided as an opening or a transparent member is formed in a portion of cover member 58 opposed to display 61. By doing so, representation on display 61 can externally readily be checked through the window portion. In output substrate 56, processor 56a is further arranged and storage portion 59 may further be arranged.

Display 61 can show data transmitted from control circuit 27 (for example, the number of times of drive of pump 29 or a time period during which pump 29 is driven in lubricating oil supply unit 20). For example, when lubricating oil supply unit 20 is controlled as shown in Fig. 16 described above, the number of times of lowering in voltage of the power storage portion to a voltage equal to or lower than the threshold value (the number of times of discharge of the lubricating oil) may be counted on a side of control circuit 27 or output substrate 56 and the number may be shown on display 61.

When a capacity of lubricating oil tank 30 and an amount of discharge of the lubricating oil each time pump 29 is driven are found in advance, the number of times that the lubricating oil can be supplied from lubricating oil tank 30 (the maximum number of times that the lubricating oil can be supplied by driving pump 29) can be known. Therefore, the remaining number of times of possible discharge can readily be known based on the number of times of drive of pump 29. The number of times of possible discharge calculated by subtracting an actual number of times (the number of times of actual drive of pump 29) from the above-described maximum number or an amount of the lubricating oil which remains in lubricating oil tank 30 may be shown as data to be shown on display 61.

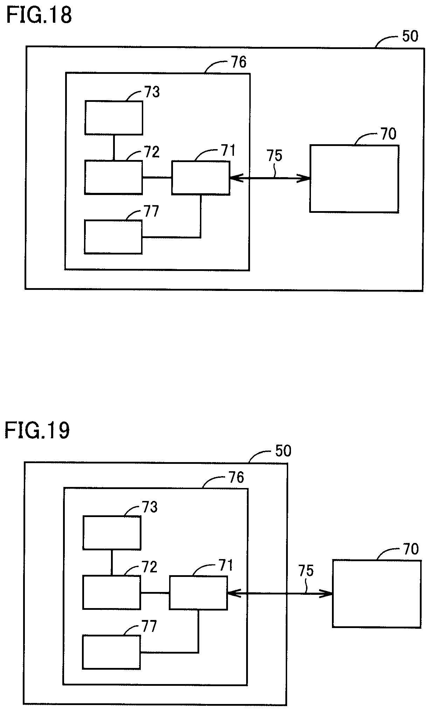

Referring to Fig. 18, a second modification of machine tool spindle 50 is basically identical in construction to machine tool spindle 50 shown in Fig. 1, however, data is transmitted from control unit 71 of unit main body portion 76 to external output portion 70 as shown with an arrow 75 through radio communication. In this case, a transmission and reception portion for radio data communication is provided in control unit 71 and external output portion 70. By doing so, it is not necessary to provide a through hole for passage of contact probe 54 in spindle housing 52 as shown in Fig. 1 and the construction of machine tool spindle 50 can be simplified.

Referring to Fig. 19, a third modification of machine tool spindle 50 is basically identical in construction to machine tool spindle 50 shown in Fig. 18, however, external output portion 70 is arranged outside machine tool spindle 50 and data is transmitted between external output portion 70 and control unit 71 through radio communication. In this case, any analyzer such as a personal computer can be employed as external output portion 70. In this case, a condition of supply of the lubricating oil to bearing 11 of machine tool spindle 50 can readily be checked by using the analyzer.

Any conventionally well-known communication standards such as wireless LAN (for example, WiFi™), Bluetooth®, or ZigBee can be made use of as a scheme for radio communication described above.

### (Second Embodiment)

### <Construction of Mechanical Apparatus>

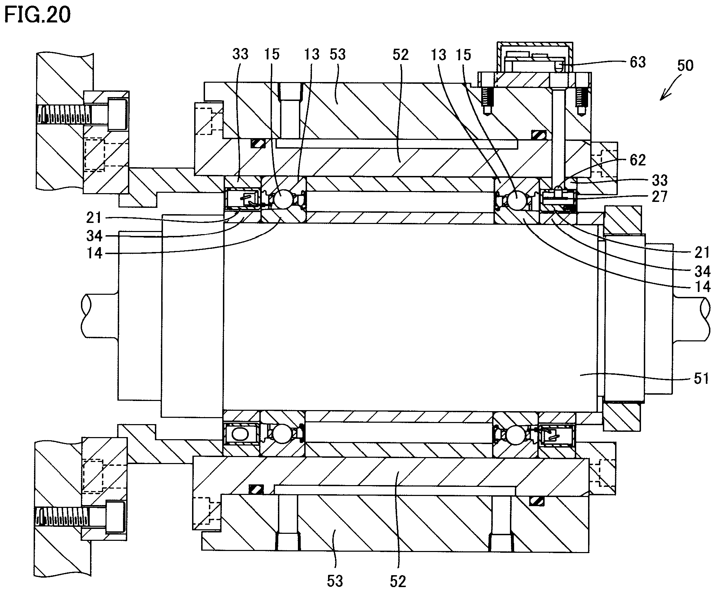

A construction of a machine tool spindle representing one example of a mechanical apparatus to which a bearing apparatus according to the present second embodiment is applied will be described with reference to Figs. 20 to 23. A mechanical apparatus (a machine tool spindle 80) according to the second embodiment is basically identical in construction to the mechanical apparatus according to the first embodiment, however, it is different in that output substrate 56 and control circuit 27 of lubricating oil supply unit 20 (see Fig. 7) included in the bearing apparatus are connected to each other through an optical communication portion 78 (a light emitting element 62 and a light reception element 63).

Control circuit 27 of lubricating oil supply unit 20 is connected to light emitting element 62. Output substrate 56 is connected to light reception element 63. For example, light emitting element 62 is mounted on a control substrate where control circuit 27 is formed. Light reception element 63 is mounted on output substrate 56.

Light emitting element 62 and light reception element 63 are arranged as being opposed to each other with a through hole lying therebetween, such that light emitted from light emitting element 62 is received by light reception element 63 through the through hole. Light emitting element 62 and light reception element 63 are arranged such that an optical axis of light emitted from light emitting element 62 passes through the through hole. Light transmitted and received between light emitting element 62 and light reception element 63 may have any wavelength, and it may be infrared light. Light emitting element 62 is provided so as to be able to emit toward light reception element 63, light resulting, for example, from superimposition of signal waves containing data on a condition of supply of the lubricating oil which will be described later on infrared light as carrier waves. For example, an infrared light emitting diode is employed as light emitting element 62. For example, a photodiode is employed as light reception element 63.

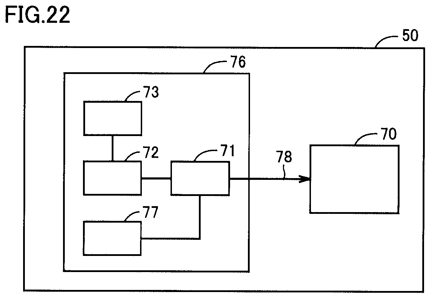

A construction of the lubricating oil supply unit including a state monitoring unit and provided in machine tool spindle 80 described above will be described mainly with reference to Fig. 22.

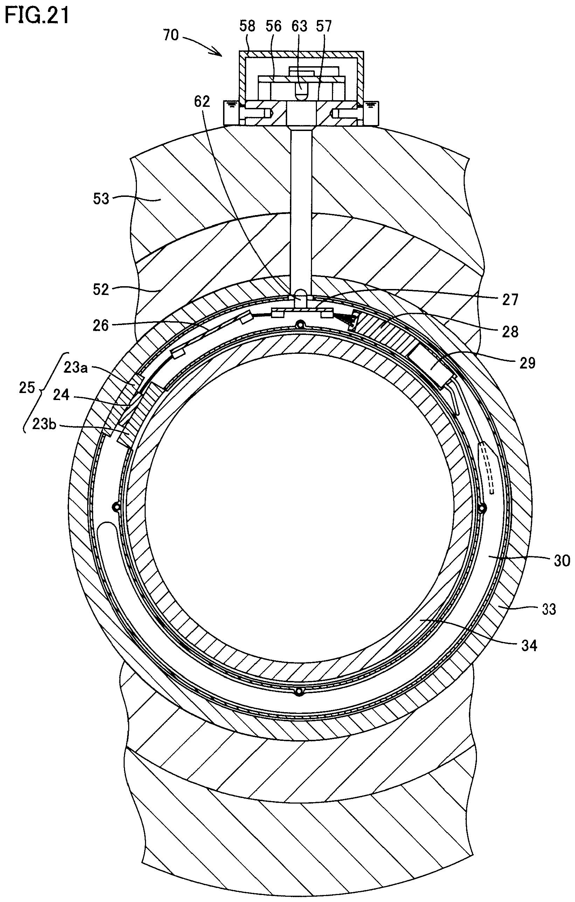

Machine tool spindle 80 described above includes a lubricating oil supply unit including unit main body portion 76 connected to bearing 11 (see Fig. 7) including inner ring 14, outer ring 13, and rolling element 15 and including control unit 71 having control circuit 27 (see Fig. 21) and external output portion 70 representing a state monitoring unit connected to control unit 71 through optical communication portion 78 (light emitting element 62 and light reception element 63). Unit main body portion 76 includes control unit 71 including control circuit 27, power supply portion 77 including power generation portion 25 (see Fig. 21) and power supply circuit 26 (see Fig. 21), lubricating oil supply portion 72 including power supply circuit 26, drive circuit 28, and pump 29, and lubricating oil holding portion 73 (lubricating oil tank 30). Control unit 71 is connected to power supply portion 77 and lubricating oil supply portion 72, controls a state of supply of a lubricating oil in lubricating oil supply portion 72, and obtains data on the state of supply of the lubricating oil. The data includes data on timing of supply of the lubricating oil, an interval of supply of the lubricating oil, and a voltage (power storage voltage) in the power supply circuit (specifically, the power storage portion) at the time of operation of pump 29, as will be described later.

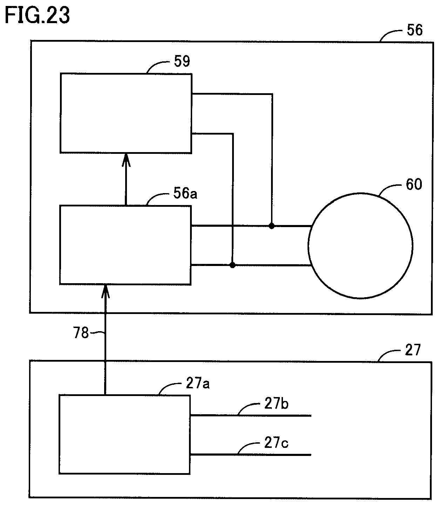

Any construction can be employed for a construction of a portion of connection between control circuit 27 of control unit 71 and output substrate 56 of external output portion 70. For example, as shown in Fig. 23, processor 27a (microcomputer) provided in control circuit 27 and processor 56a on output substrate 56 may be connected to each other through optical communication portion 78. Processor 27a of control circuit 27 is connected to a power supply or a ground portion through lines 27b and 27c. On output substrate 56, processor 56a is connected to battery 60 and storage portion 59. A signal representing data such as a voltage (a signal transmitted from control circuit 27) can be transmitted from processor 56a to storage portion 59.

### <Operations of Mechanical Apparatus>

In machine tool spindle 80 representing one example of the mechanical apparatus shown in Fig. 20, rotation shaft 51 is connected to a prescribed drive shaft so that rotation with respect to spindle housing 52 can be made. In the bearing apparatus supporting rotation shaft 51, the lubricating oil is regularly supplied to bearing 11 (see Fig. 7) by the lubricating oil supply unit so as to enhance reliability and durability of machine tool spindle 80.

### <Operations of Bearing Apparatus>

In the bearing apparatus according to the second embodiment, similarly to the bearing apparatus according to the first embodiment, the lubricating oil can be supplied from lubricating oil tank 30 to bearing 11 under control of operations of pump 29 by control circuit 27. Operations of the bearing apparatus according to the second embodiment are basically similar to the operations of the bearing apparatus according to the first embodiment described above, however, different in the following.

Data on timing of drive of pump 29 or change over time in voltage of the power storage portion is transmitted to light reception element 63 over light from light emitting element 62. Light emitting element 62 is driven by the power storage portion. Light emitting element 62 emits light, for example, by making use of electric power when the fully charged power storage portion only discharges to a resistor without driving pump 29. Upon reception of light emitted from light emitting element 62 by light reception element 63, the data is transmitted to output substrate 56.

Timing of transmission of the data by optical communication portion 78 (timing of emission of light by light emitting element 62) may be any timing. For example, electric power may be supplied from the power storage portion to light emitting element 62 during a period from drive of pump 29 by the power storage portion until next drive of pump 29 and light emitting element 62 may emit light at timing different from the timing of drive of pump 29 by the power storage portion with electric power. After pump 29 is driven a plurality of times by the power storage portion, electric power may be supplied from the power storage portion to light emitting element 62 and light emitting element 62 may emit light with that electric power. In the latter case, the data includes data on a condition of supply of the lubricating oil a plurality of times which is stored in the storage portion of control circuit 27 as described above.

When the power storage portion is provided to be able to simultaneously discharge electric power necessary for driving pump 29 and electric power necessary for driving light emitting element 62, light emitting element 62 may emit light at timing of drive of pump 29 by the power storage portion.

Control circuit 27, light reception element 63, light emitting element 62, and output substrate 56 are always set to an operating state, for example, during activation of bearing apparatus 10. Light reception element 63 is provided to be able to transmit to output substrate 56 (a light reception portion), data transmitted over light from light emitting element 62 when it receives light from light emitting element 62.

### <Modification of Construction of Mechanical Apparatus>

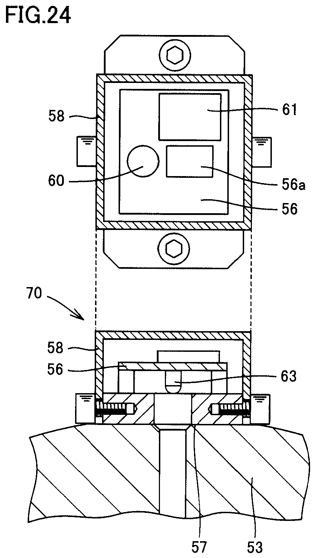

A modification of the mechanical apparatus according to the present embodiment will be described with reference to Figs. 24 to 26.

Referring to Fig. 24, a first modification of machine tool spindle 50 representing one example of the mechanical apparatus is basically identical in construction to machine tool spindle 50 shown in Fig. 20, however, display 61 is provided on output substrate 56. Any display such as a liquid crystal display can be employed as display 61. A window portion provided as an opening or a transparent member is formed in a portion of cover member 58 opposed to display 61. By doing so, representation on display 61 can externally readily be checked through the window portion. In output substrate 56, processor 56a is further arranged and storage portion 59 may further be arranged.

Display 61 can show data transmitted from control circuit 27 (for example, the number of times of drive of pump 29 or a time period during which pump 29 is driven in lubricating oil supply unit 20). For example, when lubricating oil supply unit 20 is controlled as shown in Fig. 16 described above, the number of times of lowering in voltage of the power storage portion to a voltage equal to or lower than the threshold value (the number of times of discharge of the lubricating oil) is counted on the side of control circuit 27 or output substrate 56 and the number may be shown on display 61.

When a capacity of lubricating oil tank 30 and an amount of discharge of the lubricating oil each time pump 29 is driven are found in advance, the number of times that the lubricating oil can be supplied from lubricating oil tank 30 (the maximum number of times that the lubricating oil can be supplied by driving pump 29) can be known. Therefore, the remaining number of times of possible discharge can readily be known based on the number of times of drive of pump 29. The number of times of possible discharge calculated by subtracting an actual number of times (the number of times of actual drive of pump 29) from the above-described maximum number or an amount of the lubricating oil which remains in lubricating oil tank 30 may be shown as data to be shown on display 61.

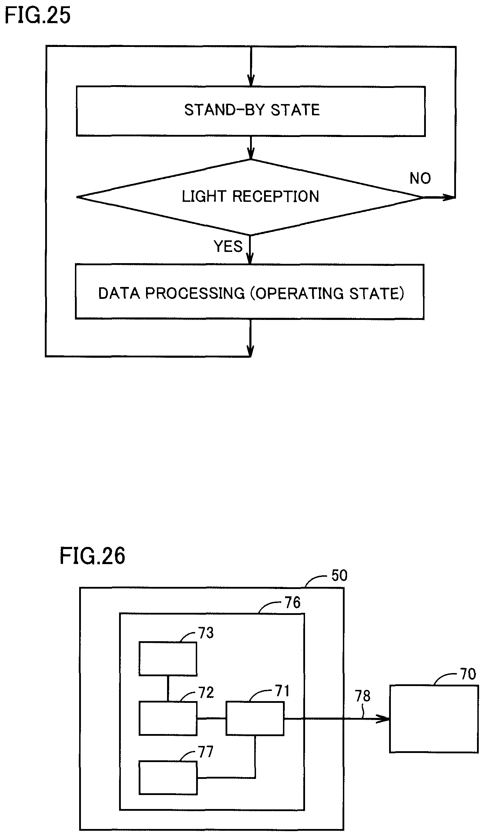

Referring to Fig. 25, output substrate 56 (the reception portion) may be configured to be able to switch between an operating state in which processing of data is performed and a stand-by state in which reception of data from light reception element 63 is awaited, in response to reception of data from light reception element 63. Output substrate 56 may be controlled such that the operating state is set in response to reception of data and thereafter the stand-by state is set after data processing. By doing so, an amount of power consumption in bearing apparatus 10 can be smaller than when output substrate 56 is always set to the operating state during activation of bearing apparatus 10.

Though display 61 may be provided to be able to always show the data, for example, the data may be shown only when an operator who handles bearing apparatus 10 does checking. For example, a display button (not shown) may be provided on output substrate 56 and processor 56a and display 61 may be provided to be activated when the operator presses the display button. By doing so, an amount of power consumption in lubricating oil supply unit 20 or bearing apparatus 10 can be smaller than in an example in which the processor and the display are always active.

Characteristic features of the embodiment of the present invention will be listed, although some are duplicate for the description above.

Lubricating oil supply unit 20 according to the embodiment of the present invention includes a holding portion (lubricating oil tank 30 or lubricating oil holding portion 73) which holds a lubricating oil supplied to the inside of bearing 11, a supply portion (drive circuit 28 and pump 29 or lubricating oil supply portion 72) which supplies the lubricating oil to the inside of bearing 11 from the holding portion, and a control unit (control circuit 27 or control unit 71) for controlling operations of the supply portion. The control unit can obtain data on a condition of supply of the lubricating oil and output the data to the outside of the control unit.

By doing so, by arranging a reception portion which receives the data output from the control unit at a position where checking is readily done such as an outer circumferential portion of lubricating oil supply unit 20, a condition of operations of lubricating oil supply unit 20 (a condition of supply of the lubricating oil) can readily be known based on the data. Therefore, occurrence of an abnormal condition can quickly be sensed. Therefore, consequently, reliability of lubricating oil supply unit 20 can be enhanced. Therefore, lubricating oil supply unit 20 which can be operated for a long period of time in a stable manner can be realized.

Lubricating oil supply unit 20 may include a reception portion (output substrate 56 or external output portion 70) which receives the data output from the control unit. The control unit may include a storage portion (a memory element provided in control circuit 27) for storing the data. The control unit may transmit the data to the reception portion at a time point at which the storage portion is filled to capacity with the data or every predetermined time. The reception portion may include a storage medium (storage portion 59) which stores the received data.

In this case, by arranging the reception portion at a position distant from the control unit (for example, a position distant from bearing 11 to which lubricating oil supply unit 20 is connected), a condition of operations of lubricating oil supply unit 20 can be stored in a storage medium in the reception portion arranged at a position distant from the control unit. Therefore, data can readily be checked by making use of a removable medium as a storage medium in the reception portion or providing a display portion which shows data stored in the storage medium in the reception portion. By setting a frequency of transmission of data to be high to some extent, it is not necessary to arrange an element large in storage capacity in the control unit of lubricating oil supply unit 20. Therefore, cost for manufacturing the control unit of the lubricating oil supply unit can be reduced.

In lubricating oil supply unit 20, the data may include time information indicating a time point at which the lubricating oil is supplied to the inside of bearing 11. The storage medium may be attachable to and removable from the reception portion.

In this case, the storage medium storing the data can be removed from the reception portion and the data can be input to an external analyzer (for example, a personal computer) by using the storage medium. Therefore, a condition of operations of lubricating oil supply unit 20 can readily be analyzed.

Lubricating oil supply unit 20 may include a reception portion which receives the data output from the control unit. The control unit may include a storage portion for storing the data. The control unit may transmit the data to the reception portion at a time point at which the storage portion is filled to capacity with the data or every predetermined time. The reception portion may include a display portion (display 61) which shows the received data.

In this case, since an operator can readily check the data shown on the display portion, a condition of operations of lubricating oil supply unit 20 (a condition of supply of the lubricating oil) can readily be known.

In lubricating oil supply unit 20, the reception portion and the control unit may be connected to each other through a conductor (contact probe 54). The data may be transmitted from the control unit to the reception portion through the conductor.

In this case, by reliably connecting the control unit and the reception portion to each other through the conductor, data can reliably be transmitted from the control unit to the reception portion through the conductor.

In lubricating oil supply unit 20, the reception portion may include battery 60 as a power supply. For example, a coin battery or a button battery can be employed for battery 60. In this case, since battery 60 can supply electric power for control of reception of data in the reception portion, it is not necessary to lay a line for external power supply to the reception portion. Therefore, restriction on a power supply in providing a lubricating oil supply unit can be lessened. When electric power obtained from power generation portion 25 included in lubricating oil supply unit 20 is made use of also in the reception portion (output substrate 56) and when it is difficult to operate output substrate 56 only with that electric power, the battery can operate output substrate 56.

In lubricating oil supply unit 20, the control unit may transmit the data to the reception portion as a radio signal as shown in Figs. 18 and 19. In this case, since it is not necessary to physically connect the control unit and the reception portion to each other through a conductive line, a structure of lubricating oil supply unit 20, a bearing apparatus to which lubricating oil supply unit 20 is connected, or a mechanical apparatus (machine tool spindle 50) including the bearing apparatus can be more simplified than in an example in which the conductive line is provided.

In lubricating oil supply unit 20, the control unit may be able to arbitrarily set an interval of activation when the supply portion is repeatedly activated for supplying the lubricating oil to the inside of bearing 11. In this case, an interval of supply of the lubricating oil can be adjusted in accordance with a condition of operations of bearing 11 by varying the interval of operation. Consequently, occurrence of such a problem as excessive supply of the lubricating oil or insufficiency in lubricating oil in bearing 11 can be suppressed.

The lubricating oil supply unit includes power generation portion 25 which generates electric power for activating the supply portion and a power storage portion (the power storage portion included in power supply circuit 26) charged with electric power generated by power generation portion 25. The supply portion may be activated with electric power discharged from the power storage portion. The power storage portion may be able to discharge without activating the supply portion. The power storage portion may be set to a first voltage value (voltage V1 in Fig. 16) after the power storage portion activated the supply portion and set to a second voltage value (voltage V3 in Fig. 16) different from the first voltage value after the power storage portion discharged without activating the supply portion. The control unit may specify timing to obtain the data based on a difference between the first voltage value and the second voltage value. The data may include the first voltage value at the time when the supply portion is activated.

In this case, since the data is obtained by the control unit based on a difference between the first voltage value and the second voltage value corresponding to presence or absence of an actual operation of the supply portion, data at the time when the supply portion is activated (that is, the lubricating oil is supplied to bearing 11) can reliably be obtained.

Since lubricating oil supply unit 20 includes power generation portion 25, the control unit or the supply portion of lubricating oil supply unit 20 can be operated without external supply of electric power. Therefore, a degree of freedom in construction of a mechanical apparatus in which lubricating oil supply unit 20 is provided can be improved.

Lubricating oil supply unit 20 includes power generation portion 25 which generates electric power for activating the supply portion and a power storage portion (a power storage portion included in power supply circuit 26) charged with electric power generated by the power generation portion. The supply portion may be activated with electric power discharged from the power storage portion. The power storage portion may be set to a first voltage value (voltage VI) after the power storage portion activated the supply portion. The control unit may include a timer for setting the interval of activation. The control unit may activate the supply portion and specify timing to obtain the data based on the timer. The data may include the first voltage value when the supply portion is activated.

In this case, an interval of supply of the lubricating oil can readily be varied by adjusting the timer. By using the timer, an interval of supply of the lubricating oil can be set independently of a condition for operations of the bearing apparatus in which lubricating oil supply unit 20 is provided.

Bearing apparatus 10 according to the embodiment of the present invention includes lubricating oil supply unit 20 and bearing 11 connected to the lubricating oil supply unit.

In this case, since the lubricating oil can be supplied from lubricating oil supply unit 20 to bearing 11 for a long period of time in a stable manner, highly reliable bearing apparatus 10 can be realized.

A mechanical apparatus (machine tool spindle 50) according to the embodiment of the present invention includes bearing apparatus 10. In this case, a highly reliable mechanical apparatus can be obtained.

Lubricating oil supply unit 20 according to the embodiment of the present invention includes a holding portion (lubricating oil tank 30 or lubricating oil holding portion 73) which holds a lubricating oil supplied to the inside of bearing 11, a supply portion (drive circuit 28 and pump 29 or lubricating oil supply portion 72) which supplies the lubricating oil to the inside of bearing 11 from the holding portion, a control unit (control circuit 27 or control unit 71) provided to control operations of the supply portion, to obtain data on a condition of supply of the lubricating oil, and to externally output data, a reception portion (output substrate 56 or external output portion 70) which receives the data output from the control unit, light emitting element 62 connected to the control unit, and light reception element 63 connected to the reception portion. Light emitting element 62 and light reception element 63 are provided such that light reception element 63 can receive light emitted from light emitting element 62. The data is transmitted from the control unit to the reception portion over the light.

By doing so, by arranging a reception portion which receives the data output from the control unit at a position where checking is readily done such as an outer circumferential portion of lubricating oil supply unit 20, a condition of operations of lubricating oil supply unit 20 (a condition of supply of the lubricating oil) can readily be known based on the data. Therefore, occurrence of an abnormal condition can quickly be sensed. Therefore, consequently, reliability of lubricating oil supply unit 20 can be enhanced. Therefore, lubricating oil supply unit 20 which can be operated for a long period of time in a stable manner can be realized. Since data is transmitted from the control unit to the reception portion without contact between light emitting element 62 and light reception element 63, lubricating oil supply unit 20 can be more simplified in structure than a contact transmission type lubricating oil supply unit in which data is transmitted through a contact point such as a connector.

Lubricating oil supply unit 20 includes power generation portion 25 which generates electric power for activating the supply portion and a power storage portion charged with electric power generated by power generation portion 25. The supply portion and light emitting element 62 may be activated with electric power discharged from the power storage portion and the power storage portion may be able to discharge without activating the supply portion.

Since lubricating oil supply unit 20 includes power generation portion 25, the control unit or the supply portion of lubricating oil supply unit 20 and light emitting element 62 can be operated without external supply of electric power. Therefore, a degree of freedom in construction of a mechanical apparatus in which lubricating oil supply unit 20 is provided can be improved.

The control unit may include a storage portion (a memory element provided in control circuit 27) for storing the data. The control unit may transmit the data to the reception portion at a time point at which the storage portion is filled to capacity with the data or every predetermined time. The reception portion may include a storage medium (storage portion 59) which stores the received data.

In this case, by arranging the reception portion at a position distant from the control unit (for example, a position distant from bearing 11 to which lubricating oil supply unit 20 is connected), a condition of operations of lubricating oil supply unit 20 can be stored in a storage medium in the reception portion arranged at a position distant from the control unit. Therefore, data can readily be checked by taking measures such as making use of a removable medium as a storage medium in the reception portion or providing a display portion which shows data stored in the storage medium in the reception portion. By setting a frequency of transmission of data to be high to some extent, it is not necessary to arrange an element large in storage capacity in the control unit of lubricating oil supply unit 20. Therefore, cost for manufacturing the control unit of the lubricating oil supply unit can be reduced.

In lubricating oil supply unit 20, the data may include time information indicating a time point at which the lubricating oil is supplied to the inside of bearing 11. The storage medium may be attachable to and removable from the reception portion.

In this case, the storage medium storing the data can be removed from the reception portion and the data can be input to an external analyzer (for example, a personal computer) by using the storage medium. Therefore, a condition of operations of lubricating oil supply unit 20 can readily be analyzed.

The control unit may include a storage portion for storing the data. The control unit may transmit the data to the reception portion at a time point at which the storage portion is filled to capacity with the data or every predetermined time. The reception portion may include a display portion (display 61) which shows the received data.

In this case, since an operator can readily check the data shown on the display portion, a condition of operations of lubricating oil supply unit 20 (a condition of supply of the lubricating oil) can readily be known.

In lubricating oil supply unit 20, the control unit may be able to arbitrarily set an interval of activation when the supply portion is repeatedly activated for supplying the lubricating oil to the inside of bearing 11. In this case, an interval of supply of the lubricating oil can be adjusted in accordance with a condition of operations of bearing 11 by varying the interval of operation. Consequently, occurrence of such a problem as excessive supply of the lubricating oil or insufficiency in lubricating oil in bearing 11 can be suppressed.

The power storage portion may be set to a first voltage value (voltage V1 in Fig. 16) after the power storage portion activated the supply portion and set to a second voltage value (voltage V3 in Fig. 16) different from the first voltage value after the power storage portion discharged without activating the supply portion. The control unit may specify timing to obtain the data based on a difference between the first voltage value and the second voltage value. The data may include the first voltage value when the supply portion is activated.

In this case, since the data is obtained by the control unit based on a difference between the first voltage value and the second voltage value corresponding to presence or absence of an actual operation of the supply portion, data at the time when the supply portion is activated (that is, the lubricating oil is supplied to bearing 11) can reliably be obtained.

Since lubricating oil supply unit 20 includes power generation portion 25, the control unit or the supply portion of lubricating oil supply unit 20 can be operated without external supply of electric power. Therefore, a degree of freedom in construction of a mechanical apparatus in which lubricating oil supply unit 20 is provided can be improved.

The power storage portion may be set to a first voltage value (voltage VI) after the power storage portion activated the supply portion. The control unit may include a timer for setting the interval of activation. The control unit may activate the supply portion and specify timing to obtain the data based on the timer. The data may include the first voltage value when the supply portion is activated.

In this case, an interval of supply of the lubricating oil can readily be varied by adjusting the timer. By using the timer, an interval of supply of the lubricating oil can be set independently of a condition for operations of the bearing apparatus in which lubricating oil supply unit 20 is provided.

Light reception element 63 may be provided to be able to receive light from light emitting element 62 and to transmit to the reception portion, data transmitted over the light when the light reception element receives the light. The reception portion may be configured to be able to switch between an operating state in which processing of the data is performed upon receiving the data from light reception element 63 and a stand-by state (a sleep state) in which reception of the data from light reception element 63 is awaited. The reception portion may be controlled such that the reception portion is set to the operating state upon receiving the data and thereafter the reception portion is set to the stand-by state after the processing.

The reception portion is smaller in amount of power consumption when it is in the stand-by state (sleep state) in which reception of data from light reception element 63 is awaited than when it is in the operating state in which processing of data is performed. Therefore, as the reception portion is controlled such that it is set to the operating state in response to reception of data and thereafter it is set to the stand-by state after the processing, power consumption in the lubricating oil supply unit can be reduced.

In lubricating oil supply unit 20, the reception portion may include battery 60 as a power supply. For example, a coin battery or a button battery can be employed for battery 60. In this case, since battery 60 can supply electric power for control of reception of data in the reception portion, it is not necessary to lay a line for external power supply to the reception portion. Therefore, restriction on a power supply in providing a lubricating oil supply unit can be lessened. When electric power obtained from power generation portion 25 included in lubricating oil supply unit 20 is made use of also in the reception portion (output substrate 56) and when it is difficult to operate output substrate 56 only with that electric power, the battery can operate output substrate 56.

Bearing apparatus 10 according to the embodiment of the present invention includes lubricating oil supply unit 20 and bearing 11 connected to the lubricating oil supply unit.

In this case, since the lubricating oil can be supplied from lubricating oil supply unit 20 to bearing 11 for a long period of time in a stable manner, highly reliable bearing apparatus 10 can be realized.

A mechanical apparatus (machine tool spindle 50) according to the embodiment of the present invention includes bearing apparatus 10. In this case, a highly reliable mechanical apparatus can be obtained.

Though the embodiment of the present invention has been described above, the embodiment described above can also variously be modified within the scope of the appended claims. The scope of the present invention is not limited to the embodiment described above but by the appended claims. The scope of the present invention is defined by the terms of the claims and is intended to include any modifications within the scope of the claims.

### INDUSTRIAL APPLICABILITY

This invention is particularly advantageously applied to a lubricating oil supply unit including a power generation portion and a bearing apparatus including the lubricating oil supply unit.

### REFERENCE SIGNS LIST

10 bearing apparatus; 11 bearing; 13 outer ring; 14 inner ring; 15 rolling element; 16 retainer; 20 lubricating oil supply unit; 21 housing main body; 22 lid; 23a, 23b heat conductor; 24 thermoelectric element; 25 power generation portion; 26 power supply circuit; 27 control circuit; 27a processor; 27b, 27c line; 28 drive circuit; 29 pump; 30 lubricating oil tank; 31 sucking tube; 32 discharge tube; 33 outer ring spacer; 34 inner ring spacer; 35 tap hole; 36 gap; 37 nozzle; 38 lubricating oil; 39 screw; 41 charging time period; 42 delay time period; 43 lubrication lifetime; 50 machine tool spindle; 51 rotation shaft; 52 spindle housing; 53 outer circumferential housing; 54 contact probe; 55 conductive line; 56 output substrate; 56a processor; 57 base; 58 cover member; 59 storage portion; 60 battery; 61 display; 62 light emitting element; 63 light reception element; 70 external output portion; 71 control unit; 72 lubricating oil supply portion; 73 lubricating oil holding portion; 74 connection line; 75 arrow; 76 unit main body portion; 77 power supply portion; and 78 optical communication portion.

## Claims

1. A lubricating oil supply unit (20) comprising:
a holding portion which holds a lubricating oil (38) supplied to inside of a bearing (11);
a supply portion which supplies the lubricating oil (38) to the inside of the bearing (11) from the holding portion; and
a control unit for controlling operations of the supply portion, whereby the lubricating oil supply unit (20) is adapted for being arranged between an inner ring spacer (34) and an outer ring spacer (33) which are arranged adjacently to the bearing (11),
the lubricating oil supply unit (20) further comprising a power generation portion (25) which generates electric power for activating the supply portion and a power storage portion charged with electric power generated by the power generation portion (25),
the power generation portion (25) including a thermoelectric element (24) fixable with the outer ring spacer (33) on an inner circumferential side and a heat conductor (23b) connected to the thermoelectric element (24) on the inner ring spacer
side,
**characterized in that** the control unit is configured to obtain data on a condition of supply of the lubricating oil (38) and to output the data to outside of the control unit.

2. The lubricating oil supply unit (20) according to claim 1, the lubricating oil supply unit (20) comprising a reception portion which receives the data output from the control unit, wherein
the control unit includes a storage portion for storing the data,
the control unit transmits the data to the reception portion at a time point at which the storage portion is filled to capacity with the data or every predetermined time, and
the reception portion includes a storage medium which stores the received data.

3. The lubricating oil supply unit (20) according to claim 2, wherein
the data includes time information indicating a time point at which the lubricating oil (38) is supplied to the inside of the bearing (11), and
the storage medium is attachable to and removable from the reception portion.

4. The lubricating oil supply unit (20) according to claim 1, the lubricating oil supply unit (20) comprising a reception portion which receives the data output from the control unit, wherein
the control unit includes a storage portion for storing the data,
the control unit transmits the data to the reception portion at a time point at which the storage portion is filled to capacity with the data or every predetermined time, and
the reception portion includes a display portion which shows the received data.

5. The lubricating oil supply unit (20) according to any one of claims 2 to 4, wherein
the reception portion and the control unit are connected to each other through a conductor, and
the data is transmitted from the control unit to the reception portion through the conductor.

6. The lubricating oil supply unit (20) according to any one of claims 2 to 4, wherein
the control unit can transmit the data to the reception portion as a radio signal.

7. The lubricating oil supply unit (20) according to any one of claims 1 to 6, wherein
the control unit can arbitrarily set an interval of activation when the supply portion is repeatedly activated for supplying the lubricating oil (38) to the inside of the bearing (11).

8. The lubricating oil supply unit (20) according to claim 7, wherein
the supply portion is activated with electric power discharged from the power storage portion,
the power storage portion can discharge without activating the supply portion, the power storage portion is set to a first voltage value after the power storage portion activated the supply portion and set to a second voltage value different from the first voltage value after the power storage portion discharged without activating the supply portion,
the control unit specifies timing to obtain the data based on a difference between the first voltage value and the second voltage value, and
the data includes the first voltage value when the supply portion is activated.

9. The lubricating oil supply unit (20) according to claim 7, wherein
the supply portion is activated with electric power discharged from the power storage portion,
the power storage portion is set to a first voltage value after the power storage portion activated the supply portion,
the control unit includes a timer for setting the interval of activation,
the control unit activates the supply portion and specifies timing to obtain the data based on the timer, and
the data includes the first voltage value when the supply portion is activated.

10. The lubricating oil supply unit (20) according to claim 1, the lubricating oil supply unit (20) comprising:
a reception portion which receives the data output from the control unit;
a light emitting element (62) connected to the control unit; and
a light reception element (63) connected to the reception portion, wherein
the light emitting element (62) and the light reception element (63) are provided such that the light reception element (63) can receive light emitted from the light emitting element (62), and
the data is transmitted from the control unit to the reception portion over the light.

11. The lubricating oil supply unit (20) according to claim 10, wherein
the supply portion and the light emitting element (62) are activated with electric power discharged from the power storage portion, and
the power storage portion can discharge without activating the supply portion.

12. The lubricating oil supply unit (20) according to claim 11, wherein
the control unit includes a storage portion for storing the data,
the control unit transmits the data to the reception portion at a time point at which the storage portion is filled to capacity with the data or every predetermined time, and
the reception portion includes a storage medium which stores the received data.

13. The lubricating oil supply unit (20) according to claim 12, wherein
the data includes time information indicating a time point at which the lubricating oil (38) is supplied to the inside of the bearing (11), and
the storage medium is attachable to and removable from the reception portion.

14. The lubricating oil supply unit (20) according to claim 13, wherein
the control unit includes a storage portion for storing the data,
the control unit transmits the data to the reception portion at a time point at which the storage portion is filled to capacity with the data or every predetermined time, and
the reception portion includes a display portion which shows the received data.

15. The lubricating oil supply unit (20) according to any one of claims 11 to 14, wherein
the control unit can arbitrarily set an interval of activation when the supply portion is repeatedly activated for supplying the lubricating oil (38) to the inside of the bearing (11).

16. The lubricating oil supply unit (20) according to claim 15, wherein
the power storage portion is set to a first voltage value after the power storage portion activated the supply portion and set to a second voltage value different from the first voltage value after the power storage portion discharged without activating the supply portion,
the control unit specifies timing to obtain the data based on a difference between the first voltage value and the second voltage value, and
the data includes the first voltage value when the supply portion is activated.

17. The lubricating oil supply unit (20) according to claim 15, wherein
the power storage portion is set to a first voltage value after the power storage portion activated the supply portion,
the control unit includes a timer for setting the interval of activation,
the control unit activates the supply portion and specifies timing to obtain the data based on the timer, and
the data includes the first voltage value when the supply portion is activated.

18. The lubricating oil supply unit (20) according to any one of claims 11 to 17, wherein
the light reception element (63) is provided to be able to receive the light from the light emitting element (62) and transmits to the reception portion, the data transmitted over the light when the light reception element (63) receives the light,
the reception portion is configured to be able to switch between an operating state in which upon receiving the data from the light reception element (63), processing of the data is performed and a stand-by state in which reception of the data from the light reception element (63) is awaited, and
the reception portion is controlled such that the reception portion is set to the operating state upon receiving the data and thereafter the reception portion is set to the stand-by state after the processing.

19. The lubricating oil supply unit (20) according to claim 5 or any one of claims 10 to 18, wherein
the reception portion includes a battery (60) as a power supply.

20. A bearing apparatus (10) comprising:
the lubricating oil supply unit (20) according to any one of claims 1 to 19; and
a bearing (11) connected to the lubricating oil supply unit (20).

## Patentansprüche

1. Schmierölzufuhreinheit (20), umfassend:
einen Speicherabschnitt, der ein Schmieröl (38) speichert, das in das Innere eines Lagers (11) geleitet wird;
einen Zufuhrabschnitt, der das Schmieröl (38) aus dem Speicherabschnitt in das Innere des Lagers (11) befördert; und
eine Steuereinheit zum Steuern des Betriebs des Zufuhrabschnitts,
wobei die Schmierölzufuhreinheit (20) dafür ausgelegt ist, zwischen einem Innenring-Abstandshalter (34) und einem Außenring-Abstandshalter (33), die neben dem Lager (11) angeordnet sind, angeordnet zu werden,
die Schmierölzufuhreinheit (20) des Weiteren einen Stromerzeugungsabschnitt (25) umfasst, der elektrische Energie zum Aktivieren des Zufuhrabschnitts erzeugt, sowie einen Stromspeicherabschnitt umfasst, der mit elektrischer Energie geladen wird, die durch den Stromerzeugungsabschnitt (25) erzeugt wird,
wobei der Stromerzeugungsabschnitt (25) ein thermoelektrisches Element (24) umfasst, das mit dem Außenring-Abstandshalter (33) an einer Innenumfangsseite befestigt werden kann, sowie einen Wärmeleiter (23b) umfasst, der mit dem thermoelektrischen Element (24) auf der Seite des Innenring-Abstandshalters verbunden ist,
**dadurch gekennzeichnet, dass**
die Steuereinheit dafür eingerichtet ist, Daten über einen Zustand der Zufuhr des Schmieröls (38) zu erhalten und die Daten nach außerhalb der Steuereinheit auszugeben.

2. Schmierölzufuhreinheit (20) nach Anspruch 1, wobei die Schmierölzufuhreinheit (20) einen Empfangsabschnitt umfasst, der die von der Steuereinheit ausgegebenen Daten empfängt, wobei
die Steuereinheit einen Speicherabschnitt zum Speichern der Daten umfasst,
die Steuereinheit die Daten an den Empfangsabschnitt an einem Zeitpunkt, an dem der Speicherabschnitt bis zur Kapazität mit den Daten gefüllt ist, oder an jedem zuvor festgelegten Zeitpunkt, überträgt und
der Empfangsabschnitt ein Speichermedium umfasst, das die empfangenen Daten speichert.

3. Schmierölzufuhreinheit (20) nach Anspruch 2, wobei
die Daten Zeitinformationen enthalten, die einen Zeitpunkt angeben, an dem das Schmieröl (38) in das Innere des Lagers (11) geleitet wird, und
das Speichermedium an den Empfangsabschnitt angebracht und von diesem abgenommen werden kann.

4. Schmierölzufuhreinheit (20) nach Anspruch 1, wobei die Schmierölzufuhreinheit (20) einen Empfangsabschnitt umfasst, der die von der Steuereinheit ausgegebenen Daten empfängt, wobei
die Steuereinheit einen Speicherabschnitt zum Speichern der Daten umfasst,
die Steuereinheit die Daten an den Empfangsabschnitt an einem Zeitpunkt, an dem der Speicherabschnitt bis zur Kapazität mit den Daten gefüllt ist, oder an jedem zuvor festgelegten Zeitpunkt, überträgt und
der Empfangsabschnitt einen Anzeigeabschnitt umfasst, der die empfangenen Daten anzeigt.

5. Schmierölzufuhreinheit (20) nach einem der Ansprüche 2 bis 4, wobei
der Empfangsabschnitt und die Steuereinheit über einen Leiter miteinander verbunden sind und
die Daten über den Leiter von der Steuereinheit zu dem Empfangsabschnitt übertragen werden.

6. Schmierölzufuhreinheit (20) nach einem der Ansprüche 2 bis 4, wobei die Steuereinheit die Daten als ein Funksignal an den Empfangsabschnitt übertragen kann.

7. Schmierölzufuhreinheit (20) nach einem der Ansprüche 1 bis 6, wobei die Steuereinheit beliebig ein Aktivierungsintervall einstellen kann, in dem der Zufuhrabschnitt wiederholt aktiviert wird, um das Schmieröl (38) in das Innere des Lagers (11) zu leiten.

8. Schmierölzufuhreinheit (20) nach Anspruch 7, wobei
der Zufuhrabschnitt mit elektrischer Energie aktiviert wird, die von dem Stromspeicherabschnitt ausgegeben wird,
der Stromspeicherabschnitt Energie abgeben kann, ohne den Zufuhrabschnitt zu aktivieren,
der Stromspeicherabschnitt auf einen ersten Spannungswert eingestellt wird, nachdem der Stromspeicherabschnitt den Zufuhrabschnitt aktiviert hat, und auf einen zweiten Spannungswert eingestellt wird, der sich von dem ersten Spannungswert unterscheidet, nachdem der Stromspeicherabschnitt Energie abgegeben hat, ohne den Zufuhrabschnitt zu aktivieren,
die Steuereinheit den Zeitpunkt für das Erhalten von Daten anhand einer Differenz zwischen dem ersten Spannungswert und dem zweiten Spannungswert spezifiziert, und
die Daten den ersten Spannungswert enthalten, wenn der Zufuhrabschnitt aktiviert wird.

9. Schmierölzufuhreinheit (20) nach Anspruch 7, wobei
der Zufuhrabschnitt mit elektrischer Energie aktiviert wird, die von dem Stromspeicherabschnitt ausgegeben wird,
der Stromspeicherabschnitt auf einen ersten Spannungswert eingestellt wird, nachdem der Stromspeicherabschnitt den Zufuhrabschnitt aktiviert hat,
die Steuereinheit einen Zeitmesser zum Einstellen des Aktivierungsintervalls umfasst, die Steuereinheit auf der Grundlage des Zeitmessers den Zufuhrabschnitt aktiviert und den Zeitpunkt zum Erhalten der Daten spezifiziert, und
die Daten den ersten Spannungswert enthalten, wenn der Zufuhrabschnitt aktiviert wird.

10. Schmierölzufuhreinheit (20) nach Anspruch 1, wobei die Schmierölzufuhreinheit (20) umfasst:
einen Empfangsabschnitt, der die von der Steuereinheit ausgegebenen Daten empfängt;
ein Leuchtelement (62), das mit der Steuereinheit verbunden ist; und
ein Lichtempfangselement (63), das mit dem Empfangsabschnitt verbunden ist, wobei
das Leuchtelement (62) und das Lichtempfangselement (63) so angeordnet sind, dass das Lichtempfangselement (63) Licht empfangen kann, das von dem Leuchtelement (62) ausgesendet wird, und
die Daten über das Licht von der Steuereinheit an den Empfangsabschnitt übertragen werden.

11. Schmierölzufuhreinheit (20) nach Anspruch 10, wobei
der Zufuhrabschnitt und das Leuchtelement (62) mit elektrischer Energie aktiviert werden, die von dem Stromspeicherabschnitt abgegeben wird, und
der Stromspeicherabschnitt Energie abgeben kann, ohne den Zufuhrabschnitt zu aktivieren.

12. Schmierölzufuhreinheit (20) nach Anspruch 11, wobei
die Steuereinheit einen Speicherabschnitt zum Speichern der Daten umfasst,
die Steuereinheit die Daten an den Empfangsabschnitt an einem Zeitpunkt, an dem der Speicherabschnitt bis zur Kapazität mit den Daten gefüllt ist, oder an jedem zuvor festgelegten Zeitpunkt, überträgt und
der Empfangsabschnitt ein Speichermedium umfasst, das die empfangenen Daten speichert.

13. Schmierölzufuhreinheit (20) nach Anspruch 12, wobei
die Daten Zeitinformationen enthalten, die einen Zeitpunkt angeben, an dem das Schmieröl (38) in das Innere des Lagers (11) geleitet wird, und
das Speichermedium an den Empfangsabschnitt angebracht und von diesem abgenommen werden kann.

14. Schmierölzufuhreinheit (20) nach Anspruch 13, wobei
die Steuereinheit einen Speicherabschnitt zum Speichern der Daten umfasst, die Steuereinheit die Daten an den Empfangsabschnitt an einem Zeitpunkt, an dem der Speicherabschnitt bis zur Kapazität mit den Daten gefüllt ist, oder an jedem zuvor festgelegten Zeitpunkt, überträgt und
der Empfangsabschnitt einen Anzeigeabschnitt umfasst, der die empfangenen Daten anzeigt.

15. Schmierölzufuhreinheit (20) nach einem der Ansprüche 11 bis 14, wobei
die Steuereinheit beliebig ein Aktivierungsintervall einstellen kann, in dem der Zufuhrabschnitt wiederholt aktiviert wird, um das Schmieröl (38) in das Innere des Lagers (11) zu leiten.

16. Schmierölzufuhreinheit (20) nach Anspruch 15, wobei
der Stromspeicherabschnitt auf einen ersten Spannungswert eingestellt wird, nachdem der Stromspeicherabschnitt den Zufuhrabschnitt aktiviert hat, und auf einen zweiten Spannungswert eingestellt wird, der sich von dem ersten Spannungswert unterscheidet, nachdem der Stromspeicherabschnitt Energie abgegeben hat, ohne den Zufuhrabschnitt zu aktivieren,
die Steuereinheit den Zeitpunkt für das Erhalten von Daten anhand einer Differenz zwischen dem ersten Spannungswert und dem zweiten Spannungswert spezifiziert, und
die Daten den ersten Spannungswert enthalten, wenn der Zufuhrabschnitt aktiviert wird.

17. Schmierölzufuhreinheit (20) nach Anspruch 15, wobei
der Stromspeicherabschnitt auf einen ersten Spannungswert eingestellt wird, nachdem der Stromspeicherabschnitt den Zufuhrabschnitt aktiviert hat,
die Steuereinheit einen Zeitmesser zum Einstellen des Aktivierungsintervalls umfasst, die Steuereinheit auf der Grundlage des Zeitmessers den Zufuhrabschnitt aktiviert und den Zeitpunkt zum Erhalten der Daten spezifiziert, und
die Daten den ersten Spannungswert enthalten, wenn der Zufuhrabschnitt aktiviert wird.

18. Schmierölzufuhreinheit (20) nach einem der Ansprüche 11 bis 17, wobei
das Lichtempfangselement (63) dafür eingerichtet ist, das Licht von dem Leuchtelement (62) empfangen zu können, und die über das Licht übertragenen Daten an den Empfangsabschnitt sendet, wenn das Lichtempfangselement (63) das Licht empfängt, der Empfangsabschnitt dafür eingerichtet ist, umschalten zu können zwischen: einem Betriebszustand, in dem beim Empfang der Daten von dem Lichtempfangselement (63) die Verarbeitung der Daten durchgeführt wird, und einem Bereitschaftszustand, in dem der Empfang der Daten von dem Lichtempfangselement (63) erwartet wird, und
der Empfangsabschnitt so gesteuert wird, dass der Empfangsabschnitt beim Empfang der Daten in den Betriebszustand versetzt wird, und der Empfangsabschnitt danach, nach der Verarbeitung, in den Bereitschaftszustand versetzt wird.

19. Schmierölzufuhreinheit (20) nach Anspruch 5 oder einem der Ansprüche 10 bis 18, wobei
der Empfangsabschnitt eine Batterie (60) als Stromversorgung umfasst.

20. Lagervorrichtung (10), umfassend:
die Schmierölzufuhreinheit (20) nach einem der Ansprüche 1 bis 19; und
ein Lager (11), das mit der Schmierölzufuhreinheit (20) verbunden ist.

## Revendications

1. Unité d'alimentation en huile lubrifiante (20) comprenant :
une partie de contenance qui contient une huile lubrifiante (38) alimentant l'intérieur d'un palier (11) ;
une partie d'alimentation qui alimente l'intérieur du palier (11) en huile lubrifiante (38) à partir de la partie de contenance ; et
une unité de commande destinée à régir les opérations de la partie d'alimentation,
moyennant quoi l'unité d'alimentation en huile lubrifiante (20) est conçue pour être placée entre une entretoise de bague intérieure (34) et une entretoise de bague extérieure (33) qui sont placées à proximité du palier (11),
l'unité d'alimentation en huile lubrifiante (20) comprenant en outre une partie de production d'énergie (25) qui produit de l'énergie électrique destinée à activer la partie d'alimentation et une partie de stockage d'énergie chargée en énergie électrique produite par la partie de production d'énergie (25),
la partie de production d'énergie (25) comportant un élément thermoélectrique (24) pouvant être fixé avec l'entretoise de bague extérieure (33) sur un côté circonférentiel intérieur et un conducteur de chaleur (23b) connecté à l'élément thermoélectrique (24) du côté entretoise de bague intérieure,
**caractérisée en ce**
**que** l'unité de commande est configurée pour obtenir des données sur un état d'alimentation en huile lubrifiante (38) et pour délivrer les données à l'extérieur de l'unité de commande.

2. Unité d'alimentation en huile lubrifiante (20) selon la revendication 1, l'unité d'alimentation en huile lubrifiante (20) comprenant une partie de réception qui reçoit les données délivrées par l'unité de commande, dans laquelle :
l'unité de commande comporte une partie de stockage destinée à stocker les données,
l'unité de commande transmet les données à la partie de réception à un point temporel auquel la partie de stockage est remplie au maximum de sa capacité avec les données ou à chaque moment prédéterminé, et
la partie de réception comporte un support de stockage qui stocke les données reçues.

3. Unité d'alimentation en huile lubrifiante (20) selon la revendication 2, dans laquelle :
les données incluent des informations temporelles indiquant un point temporel auquel l'huile lubrifiante (38) est fournie à l'intérieur du palier (11), et
le support de stockage peut être fixé et retiré de la partie de réception.

4. Unité d'alimentation en huile lubrifiante (20) selon la revendication 1, l'unité d'alimentation en huile lubrifiante (20) comprenant une partie de réception qui reçoit les données délivrées par l'unité de commande, dans laquelle :
l'unité de commande comporte une partie de stockage destinée à stocker les données,
l'unité de commande transmet les données à l'unité de réception à un point temporel auquel la partie de stockage est remplie au maximum de sa capacité avec les données ou à chaque moment prédéterminé, et
la partie de réception comporte une partie d'affichage qui présente les données reçues.

5. Unité d'alimentation en huile lubrifiante (20) selon l'une quelconque des revendications 2 à 4, dans laquelle :
la partie de réception et l'unité de commande sont connectées l'une à l'autre par l'intermédiaire d'un conducteur, et
les données sont transmises de l'unité de commande à la partie de réception par l'intermédiaire du conducteur.

6. Unité d'alimentation en huile lubrifiante (20) selon l'une quelconque des revendications 2 à 4, dans laquelle :
l'unité de commande peut transmettre les données à la partie de réception sous la forme d'un signal radioélectrique.

7. Unité d'alimentation en huile lubrifiante (20) selon l'une quelconque des revendications 1 à 6, dans laquelle :
l'unité de commande peut régler arbitrairement un intervalle d'activation auquel la partie d'alimentation est activée de façon répétée pour alimenter l'intérieur du palier (11) en huile lubrifiante (38).

8. Unité d'alimentation en huile lubrifiante (20) selon la revendication 7, dans laquelle :
la partie d'alimentation est activée par l'énergie électrique déchargée depuis la partie de stockage d'énergie,
la partie de stockage d'énergie peut se décharger sans activer la partie d'alimentation,
la partie de stockage d'énergie est réglée à une première valeur de tension après que la partie de stockage d'énergie a activé la partie d'alimentation et est réglée à une seconde valeur de tension différente de la première valeur de tension après que la partie de stockage d'énergie s'est déchargée sans activer la partie d'alimentation,
l'unité de commande spécifie un positionnement temporel pour obtenir les données sur la base d'une différence entre la première valeur de tension et la seconde valeur de tension, et
les données incluent la première valeur de tension lorsque la partie d'alimentation est activée.

9. Unité d'alimentation en huile lubrifiante (20) selon la revendication 7, dans laquelle :
la partie d'alimentation est activée par l'énergie électrique déchargée depuis la partie de stockage d'énergie,
la partie de stockage d'énergie est réglée à une première valeur de tension après que la partie de stockage d'énergie a activé la partie d'alimentation,
l'unité de commande comporte un compteur de temps permettant de régler l'intervalle d'activation,
l'unité de commande active la partie d'alimentation et spécifie un positionnement temporel pour obtenir les données sur la base du compteur de temps, et
les données incluent la première valeur de tension lorsque la partie d'alimentation est activée.

10. Unité d'alimentation en huile lubrifiante (20) selon la revendication 1, l'unité d'alimentation en huile lubrifiante (20) comprenant :
une partie de réception qui reçoit les données délivrées par l'unité de commande ;
un élément émetteur de lumière (62) connecté à l'unité de commande ; et
un élément de réception de lumière (63) connecté à la partie de réception, dans laquelle :
l'élément émetteur de lumière (62) et l'élément de réception de lumière (63) sont disposés de manière que l'élément de réception de lumière (63) puisse recevoir la lumière émise par l'élément émetteur de lumière (62), et
les données sont transmises de l'unité de commande à la partie de réception par la lumière.

11. Unité d'alimentation en huile lubrifiante (20) selon la revendication 10, dans laquelle :
la partie d'alimentation et l'élément émetteur de lumière (62) sont activés par l'énergie électrique déchargée depuis la partie de stockage d'énergie, et
la partie de stockage d'énergie peut se décharger sans activer la partie d'alimentation.

12. Unité d'alimentation en huile lubrifiante (20) selon la revendication 11, dans laquelle :
l'unité de commande comporte une partie de stockage destinée à stocker les données,
l'unité de commande transmet les données à la partie de réception à un point temporel auquel la partie de stockage est remplie au maximum de sa capacité avec les données ou à chaque moment prédéterminé, et
la partie de réception comporte un support de stockage qui stocke les données reçues.

13. Unité d'alimentation en huile lubrifiante (20) selon la revendication 12, dans laquelle :
les données incluent des informations temporelles indiquant un point temporel auquel l'huile lubrifiante (38) est fournie à l'intérieur du palier (11), et
le support de stockage peut être fixé et retiré de la partie de réception.

14. Unité d'alimentation en huile lubrifiante (20) selon la revendication 13, dans laquelle :
l'unité de commande comporte une partie de stockage destinée à stocker les données,
l'unité de commande transmet les données à la partie de réception à un point temporel auquel la partie de stockage est remplie au maximum de sa capacité avec les données ou à chaque moment prédéterminé, et
la partie de réception comporte une partie d'affichage qui présente les données reçues.

15. Unité d'alimentation en huile lubrifiante (20) selon l'une quelconque des revendications 11 à 14, dans laquelle :
l'unité de commande peut régler arbitrairement un intervalle d'activation auquel la partie d'alimentation est activée de façon répétée pour alimenter l'intérieur du palier (11) en huile lubrifiante (38).

16. Unité d'alimentation en huile lubrifiante (20) selon la revendication 15, dans laquelle :
la partie de stockage d'énergie est réglée à une première valeur de tension après que la partie de stockage d'énergie a activé la partie d'alimentation et est réglée à une seconde valeur de tension différente de la première valeur de tension après que la partie de stockage d'énergie s'est déchargée sans activer la partie d'alimentation,
l'unité de commande spécifie un positionnement temporel pour obtenir les données sur la base d'une différence entre la première valeur de tension et la seconde valeur de tension, et
les données incluent la première valeur de tension lorsque la partie d'alimentation est activée.

17. Unité d'alimentation en huile lubrifiante (20) selon la revendication 15, dans laquelle :
la partie de stockage d'énergie est réglée à une première valeur de tension après que la partie de stockage d'énergie a activé la partie d'alimentation,
l'unité de commande comporte un compteur de temps permettant de régler l'intervalle d'activation,
l'unité de commande active la partie d'alimentation et spécifie un positionnement temporel pour obtenir les données sur la base du compteur de temps, et
les données incluent la première valeur de tension lorsque la partie d'alimentation est activée.

18. Unité d'alimentation en huile lubrifiante (20) selon l'une quelconque des revendications 11 à 17, dans laquelle :
l'élément de réception de lumière (63) est disposé pour être apte à recevoir la lumière provenant de l'élément émetteur de lumière (62) et transmet à la partie de réception les données transmises par la lumière lorsque l'élément de réception de lumière (63) reçoit la lumière,
la partie de réception est configurée pour être apte à commuter entre un état de fonctionnement dans lequel, à la réception des données en provenance de l'élément de réception de lumière (63), un traitement des données est effectué, et un état de veille dans lequel la réception des données en provenance de l'élément de réception de lumière (63) est attendue, et
la partie de réception est commandée de manière que la partie de réception soit mise à l'état de fonctionnement à la réception des données et que la partie de réception soit mise ensuite à l'état de veille après le traitement.

19. Unité d'alimentation en huile lubrifiante (20) selon la revendication 5 ou l'une quelconque des revendications 10 à 18, dans laquelle :
la partie de réception comporte une batterie (60) en tant qu'alimentation électrique.

20. Appareil de palier (10) comprenant :
l'unité d'alimentation en huile lubrifiante (20) selon l'une quelconque des revendications 1 à 19 ; et
un palier (11) relié à l'unité d'alimentation en huile lubrifiante (20).
